# EUROPEAN PATENT APPLICATION

(11) **EP 2 333 829 A2**
(43) Date of publication of application: **15.06.2011**
(21) Application number: 11156757.4
(22) Date of filing: 31.07.2009
(51) Int. Cl.: H01L 23/373, H01L 23/38, H01L 23/46, H01L 35/32, H01L 35/08

(54) **Enhanced Thermally Isolated Thermoelectrics**

(30) Priority: 01.08.2008 US 137747 P
(62) Divisional of application: 09791076.4
(71) Applicant: BSST LLC, Irwindale, California 91706-2058 (US)
(72) Inventor: The designation of the inventor has not yet been filed
(74) Representative: Vossius & Partner

(57) **Abstract**

In certain embodiments, a thermoelectric system includes at least one cell. The at least one cell can include a first plurality of electrically conductive shunts extending along a first direction, a second plurality of electrically conductive shunts extending along a second direction non-parallel to the first direction, and a first plurality of thermoelectric (TE) elements. The first plurality of TE elements can include a first TE element between and in electrical communication with a first shunt of the first plurality of shunts and a second shunt of the second plurality of shunts, a second TE element between and in electrical communication with the second shunt and a third shunt of the first plurality of shunts, and a third TE element between and in electrical communication with the third shunt and a fourth shunt of the second plurality of shunts.

## Description

This application claims the benefit of U.S. Provisional Application No. 61/137,747 filed August 1, 2008, which is incorporated herein in its entirety by reference.

### BACKGROUND

### Field of the Invention

The present application relates to improved configurations for solid-state cooling, heating and power generation systems.

### Description of the Related Art

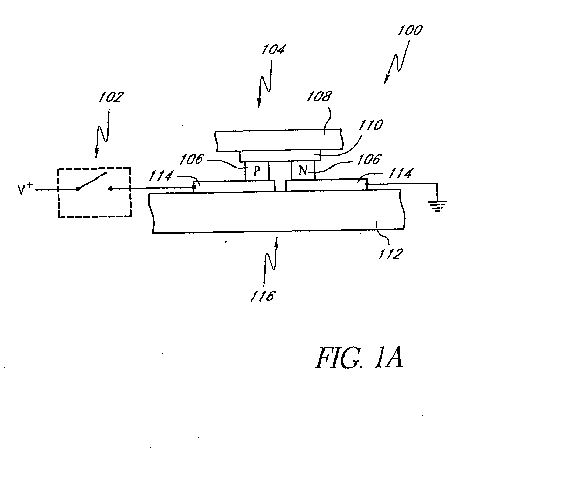

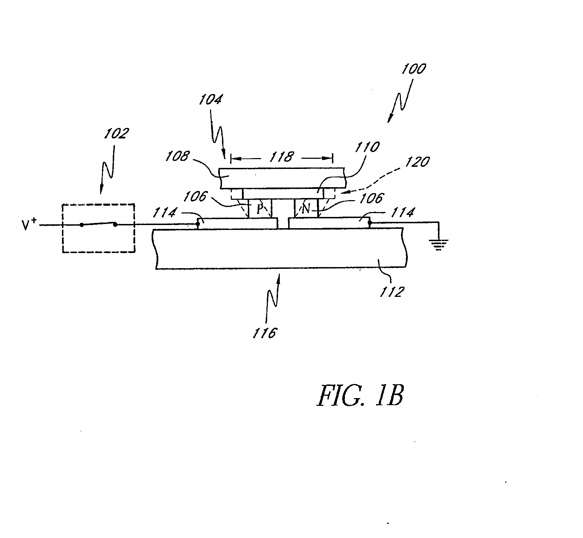

The design of thermoelectric (e.g. TE) coolers, heaters, and power generators is often compromised by the constraint to keep thermal shear stresses induced by the differential thermal expansion of the hot and cold sides below limits that induce premature failure. The shear stresses induced can cause immediate failure (e.g. breakage, etc.) of the parts or rapid fatigue failure so that robustness and operating life are unacceptably short. Figure 1A illustrates a typical TE module 100 in an unpowered state, and Figure 1B illustrates the TE module 100 with power applied (e.g. operated in cooling/heating mode) or with a temperature differential induced between top to bottom sides (e.g. operated in power generation mode). For explanatory purposes, the TE module 100 illustrated in Figure 1A is configured to operate in cooling/heating mode so that when the switch 102 is closed, the upper side 104 is heated. When no current is flowing, the TE module 100 is assumed to not have shear stresses induced in the TE elements 106 by the top substrate 108 and/or shunts 110 and the lower substrates 112 and/or shunts 114. A temperature differential across the TE elements 106 induces dimensional changes 118 in the upper hot side 104 due to the coefficient of thermal expansion (CTE) of the substrate and the shunts, as illustrated in Figure 1B. This relative movement between the upper hot side 104 and the lower cold side 116 of the TE module 100 results in thermally induced shear stresses 120, as indicated by the dotted lines in Figure 1B. If the induced motion is large enough, either because of geometrical factors and/or thermal conditions, the stress limits of the material system may be exceeded and the system may fail immediately or degrade with repeated application of the temperature differential.

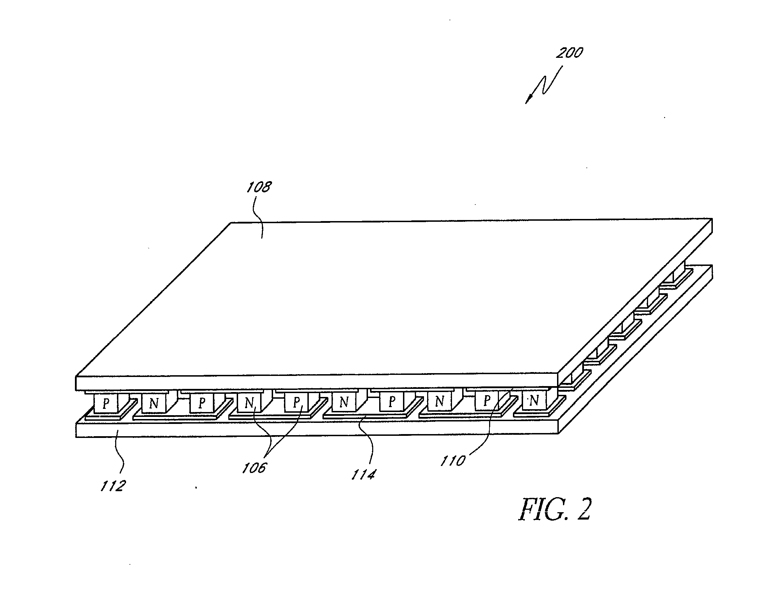

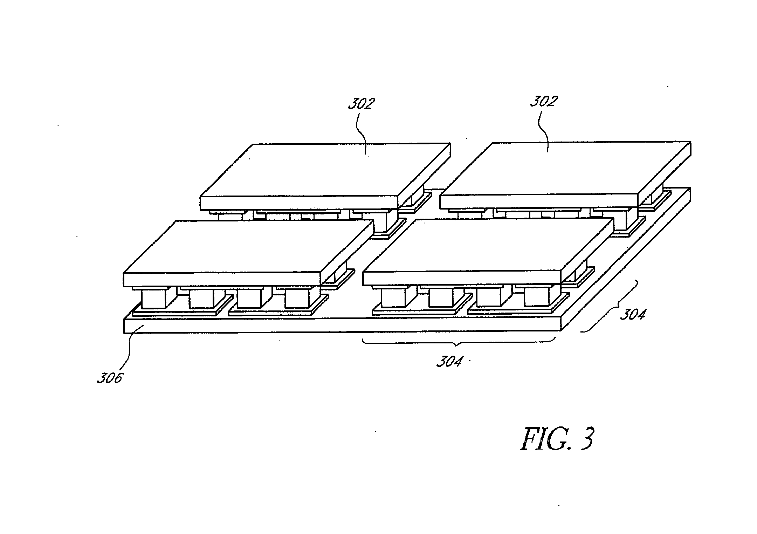

These conditions are understood by manufacturers of typical TE systems 200, as depicted in Figure 2, and result in design limitations that affect size, maximum cyclical temperature excursions and the number of operating cycles to failure. To improve durability, various design features have been used including segmentation of a first substrate 302, as depicted in Figure 3, so that the TE system 300 effectively has a second substrate which supports a number of smaller TE sub-modules 304. This approach and other approaches that allow some flexibility between top 302 and bottom 306 substrates have been used to reduce temperature differential induced stresses (*see*, *e.g.,* U.S. Patent No. 6,672,076).

### SUMMARY

In certain embodiments, a thermoelectric system includes at least one cell. The at least one cell can include a first plurality of electrically conductive shunts extending along a first direction, a second plurality of electrically conductive shunts extending along a second direction non-parallel to the first direction, and a first plurality of thermoelectric (TE) elements. The first plurality of TE elements can include a first TE element between and in electrical communication with a first shunt of the first plurality of shunts and a second shunt of the second plurality of shunts, a second TE element between and in electrical communication with the second shunt and a third shunt of the first plurality of shunts, and a third TE element between and in electrical communication with the third shunt and a fourth shunt of the second plurality of shunts. Current can flow substantially parallel to the first direction through the first shunt, through the first TE element, substantially parallel to the second direction through the second shunt, through the second TE element, substantially parallel to the first direction through the third shunt, through the third TE element, and substantially parallel to the second direction through the fourth shunt.

In certain embodiments, a thermoelectric system includes a first heat transfer structure having a first portion and a second portion. The second portion can be configured to be in thermal communication with a first working medium. The thermoelectric system can include a second heat transfer structure having a first portion and a second portion. The second portion can be configured to be in thermal communication with a second working medium. The thermoelectric system can include a third heat transfer structure having a first portion and a second portion. The second portion can be configured to be in thermal communication with the first working medium. The thermoelectric system can include a first plurality of thermoelectric (TE) elements sandwiched between the first portion of the first heat transfer structure and the first portion of the second heat transfer structure, and a second plurality of TE elements sandwiched between the first portion of the second heat transfer structure and the first portion of the third heat transfer structure, so as to form a stack of TE elements and heat transfer structures. The second portion of the first heat transfer structure and the second portion of the third heat transfer structure can project away from the stack in a first direction, and the second portion of the second heat transfer structure can project away from the stack in a second direction generally opposite to the first direction.

In certain embodiments, a thermoelectric system includes an elongate shunt that includes a plurality of layers, a first thermoelectric (TE) element on a first side of the shunt and in electrical communication and in thermal communication with the shunt, a second TE element on the first side of the shunt and in electrical communication and in thermal communication with the shunt, and a heat transfer structure on a second side of the shunt and in thermal communication with the shunt.

In certain embodiments, a thermoelectric system includes a heat transfer structure that includes a first conduit configured to allow working medium to flow in thermal communication with the first conduit and at least one second conduit configured to allow working medium to flow in thermal communication with the at least one second conduit, and a first plurality of thermoelectric (TE) elements generally in series electrical communication with one another. The first plurality of TE elements can include a first number of TE elements in thermal communication with a first side of the first conduit and substantially thermally isolated from the at least one second conduit, and a second number of TE elements in thermal communication with a first side of the at least one second conduit and substantially thermally isolated from the first conduit. The thermoelectric system can include a second plurality of TE elements generally in series electrical communication with one another. The second plurality of TE elements includes a third number of TE elements in thermal communication with a second side of the first conduit and substantially thermally isolated from the at least one second conduit, and a fourth number of TE elements in thermal communication with a second side of the at least one second conduit and substantially thermally isolated from the first conduit. The thermoelectric system can include a first plurality of electrically conductive shunts in electrical communication with the first number of TE elements and with the third number of TE elements, such that at least some of the first plurality of TE elements are in parallel electrical communication with at least some of the second plurality of TE elements.

In certain embodiments, a thermoelectric system includes a first plurality of thermoelectric (TE) elements generally in series electrical communication with one another. The first plurality of TE elements can be electrically connected to one another in series by a first plurality of electrically conductive shunts. The thermoelectric system can include a second plurality of TE elements generally in series electrical communication with one another. The second plurality of TE elements can be electrically connected to one another in series by a second plurality of electrically conductive shunts. The thermoelectric system can include at least one electrically conductive element in electrical communication with at least one of the first plurality of electrically conductive shunts and with at least one of the second plurality of electrically conductive shunts. At least a portion of the first plurality of TE elements is electrically connected in parallel to at least a portion of the second plurality of TE elements by the at least one electrically conductive element.

In certain embodiments, a thermoelectric system includes at least one thermoelectric (TE) element, and a heat transfer device in thermal communication with the at least one TE element. The heat transfer device can be configured to allow working medium to flow in thermal communication with the heat transfer device. The heat transfer device can include a heterogeneous material having a first thermal conductivity in a direction of working medium flow and a second thermal conductivity in a direction generally perpendicular to the direction of working medium flow. The second thermal conductivity can be higher than the first thermal conductivity.
The following aspects are preferred embodiments of the invention.
1. A thermoelectric system comprising at least one cell comprising:
   a first plurality of electrically conductive shunts extending along a first direction;
   a second plurality of electrically conductive shunts extending along a second direction non-parallel to the first direction; and
   a first plurality of thermoelectric (TE) elements comprising:
      a first TE element between and in electrical communication with a first shunt of the first plurality of shunts and a second shunt of the second plurality of shunts;
      a second TE element between and in electrical communication with the second shunt and a third shunt of the first plurality of shunts; and
      a third TE element between and in electrical communication with the third shunt and a fourth shunt of the second plurality of shunts, wherein current flows substantially parallel to the first direction through the first shunt, through the first TE element, substantially parallel to the second direction through the second shunt, through the second TE element, substantially parallel to the first direction through the third shunt, through the third TE element, and substantially parallel to the second direction through the fourth shunt.
2. The thermoelectric system of aspect 1, wherein the current flows through the first shunt and the third shunt in substantially parallel directions to one another and the current flows through the second shunt and the fourth shunt in substantially antiparallel directions to one another.
3. The thermoelectric system of aspect 1, wherein the cell further comprises a fourth TE element in electrical communication with the fourth shunt, wherein the current flows through the fourth TE element.
4. The thermoelectric system of aspect 3, wherein the at least one cell comprises a plurality of cells which are in electrical series with one another.
5. The thermoelectric system of aspect 1, further comprising at least one heat exchanger in thermal communication with at least some of the first plurality of TE elements, the at least one heat exchanger configured to allow a first working medium to flow through the at least one heat exchanger.
6. The thermoelectric system of aspect 5, wherein at least some of the first working medium flows in a direction substantially parallel to the second direction.
7. The thermoelectric system of aspect 5, wherein the TE elements of the first plurality of TE elements are arranged in a first row and a second row substantially parallel to one another, with the first TE element and the second TE element in the first row and the third TE element in the second row.
8. The thermoelectric system of aspect 7, wherein the at least one heat exchanger comprises a first heat exchanger in thermal communication with at least some of the first row of TE elements and a second heat exchanger in thermal communication with at least some of the second row of TE elements.
9. The thermoelectric system of aspect 8, wherein the first heat exchanger has a first side and a second side, the first side of the first heat exchanger in thermal communication with at least some of the first row of TE elements, and the second heat exchanger has a first side and a second side, the first side of the second heat exchanger in thermal communication with at least some of the second row of TE elements, wherein the thermoelectric system further comprises:
   a third plurality of electrically conductive shunts extending along the first direction and in thermal communication with at least one of the second side of the first heat exchanger and the second side of the second heat exchanger;
   a fourth plurality of electrically conductive shunts extending along the second direction; and
   a second plurality of TE elements comprising:
      a fourth TE element between and in electrical communication with a fifth shunt of the third plurality of shunts and a sixth shunt of the fourth plurality of shunts; and
      a fifth TE element between and in electrical communication with the sixth shunt and a seventh shunt of the third plurality of shunts; and
      a sixth TE element between and in electrical communication with the seventh shunt and an eighth shunt of the fourth plurality of shunts, wherein current flows substantially parallel to the first direction through the fifth shunt, through the fourth TE element, substantially parallel to the second direction through the sixth shunt, through the fifth TE element, substantially parallel to the first direction through the seventh shunt, through the sixth TE element, and substantially parallel to the second direction through the eighth shunt.
10. The thermoelectric system of aspect 9, wherein the TE elements of the second plurality of TE elements are arranged in a third row and a fourth row substantially parallel to one another and substantially parallel to the first and second rows, with the fourth TE element and the fifth TE element in the third row and the sixth TE element in the fourth row.
11. The thermoelectric system of aspect 10, wherein the first heat exchanger is in thermal communication with the third row of TE elements and the second heat exchanger is in thermal communication with the fourth row of TE elements.
12. The thermoelectric system of aspect 11, further comprising a third heat exchanger in thermal communication with the first plurality of TE elements and configured to allow a second working medium to flow therethrough.
13. The thermoelectric system of aspect 12, further comprising a fourth heat exchanger in thermal communication with the second plurality of TE elements and configured to allow the second working medium to flow therethrough.
14. The thermoelectric system of aspect 12, wherein the third heat exchanger comprises a plurality of fins.
15. A thermoelectric system comprising:
   a first heat transfer structure having a first portion and a second portion, the second portion configured to be in thermal communication with a first working medium;
   a second heat transfer structure having a first portion and a second portion, the second portion configured to be in thermal communication with a second working medium;
   a third heat transfer structure having a first portion and a second portion, the second portion configured to be in thermal communication with the first working medium;
   a first plurality of thermoelectric (TE) elements sandwiched between the first portion of the first heat transfer structure and the first portion of the second heat transfer structure; and
   a second plurality of TE elements sandwiched between the first portion of the second heat transfer structure and the first portion of the third heat transfer structure, so as to form a stack of TE elements and heat transfer structures, the second portion of the first heat transfer structure and the second portion of the third heat transfer structure projecting away from the stack in a first direction, the second portion of the second heat transfer structure projecting away from the stack in a second direction generally opposite to the first direction.
16. The thermoelectric system of aspect 15, wherein the first plurality of TE elements are in parallel electrical communication with one another and the second plurality of TE elements are in parallel electrical communication with one another.
17. The thermoelectric system of aspect 15, wherein the first heat transfer structure comprises a plurality of thermally conductive segments spaced from one another in a direction generally perpendicular to a direction of electrical current through the stack and the third heat transfer structure comprises a plurality of thermally conductive segments spaced from one another in a direction generally perpendicular to a direction of electrical current through the stack.
18. The thermoelectric system of aspect 17, wherein the second heat transfer structure comprises a plurality of thermally conductive segments and one or more electrically insulative spacers between the segments of the second heat transfer structure.
19. The thermoelectric system of aspect 15, wherein at least some of the first plurality of TE elements are generally in series electrical communication with one another and at least some of the second plurality of TE elements are generally in series electrical communication with one another.
20. The thermoelectric system of aspect 15, further comprising a material having a lower elastic modulus than the first plurality of TE elements, the material sandwiched between at least one first portion and a neighboring TE element within the stack.
21. The thermoelectric system of aspect 20, further comprises a support structure which holds the stack under compressive force in a direction generally along the stack.
22. A thermoelectric system comprising:
   an elongate shunt comprising a plurality of layers;
   a first thermoelectric (TE) element on a first side of the shunt and in electrical communication and in thermal communication with the shunt;
   a second TE element on the first side of the shunt and in electrical communication and in thermal communication with the shunt; and
   a heat transfer structure on a second side of the shunt and in thermal communication with the shunt.
23. The thermoelectric system of aspect 22, wherein the plurality of layers comprises a first layer and at least one second layer, the at least one second layer comprising at least a portion of the first side of the shunt.
24. The thermoelectric system of aspect 23, wherein the at least one second layer does not distort substantially the curvature of the first layer.
25. The thermoelectric system of aspect 24, wherein the first layer comprises a lightweight and electrically conductive material and at least a portion of the second layer comprises a solderable material.
26. The thermoelectric system of aspect 24, wherein the first TE element is spaced from the second TE element.
27. The thermoelectric system of aspect 24, wherein at least a portion of the shunt comprises a thermally active material.
28. A thermoelectric system comprising:
   a heat transfer structure comprising a first conduit configured to allow working medium to flow in thermal communication with the first conduit and at least one second conduit configured to allow working medium to flow in thermal communication with the at least one second conduit;
   a first plurality of thermoelectric (TE) elements generally in series electrical communication with one another, the first plurality of TE elements comprising:
      a first number of TE elements in thermal communication with a first side of the first conduit and substantially thermally isolated from the at least one second conduit; and
      a second number of TE elements in thermal communication with a first side of the at least one second conduit and substantially thermally isolated from the first conduit;
   a second plurality of TE elements generally in series electrical communication with one another, the second plurality of TE elements comprising:
      a third number of TE elements in thermal communication with a second side of the first conduit and substantially thermally isolated from the at least one second conduit; and
      a fourth number of TE elements in thermal communication with a second side of the at least one second conduit and substantially thermally isolated from the first conduit; and
   a first plurality of electrically conductive shunts in electrical communication with the first number of TE elements and with the third number of TE elements, such that at least some of the first plurality of TE elements are in parallel electrical communication with at least some of the second plurality of TE elements.
29. The thermoelectric system of aspect 28, wherein the at least one second conduit comprises a plurality of conduits.
30. The thermoelectric system of aspect 29, wherein the at least one second conduit comprises two conduits.
31. A thermoelectric system comprising:
   a first plurality of thermoelectric (TE) elements generally in series electrical communication with one another, wherein the first plurality of TE elements are electrically connected to one another in series by a first plurality of electrically conductive shunts,
   a second plurality of TE elements generally in series electrical communication with one another, wherein the second plurality of TE elements are electrically connected to one another in series by a second plurality of electrically conductive shunts,
   at least one electrically conductive element in electrical communication with at least one of the first plurality of electrically conductive shunts and with at least one of the second plurality of electrically conductive shunts, wherein at least a portion of the first plurality of TE elements is electrically connected in parallel to at least a portion of the second plurality of TE elements by the at least one electrically conductive element.
32. A thermoelectric system comprising:
   at least one thermoelectric (TE) element; and
   a heat transfer device in thermal communication with the at least one TE element, the heat transfer device configured to allow working medium to flow in thermal communication with the heat transfer device, the heat transfer device comprising a heterogeneous material having a first thermal conductivity in a direction of working medium flow and a second thermal conductivity in a direction generally perpendicular to the direction of working medium flow, the second thermal conductivity higher than the first thermal conductivity.
33. The thermoelectric system of aspect 32, wherein the heat transfer device comprises a ribbon comprising a first plurality of threads extending along the direction of working medium flow and a second plurality of threads extending along another the direction.
34. The thermoelectric system of aspect 33, wherein the first plurality of threads comprise a first material and the second plurality of threads comprise a second material having a thermal conductivity higher than the first material.
35. The thermoelectric system of aspect 34, wherein the first material is selected from the group consisting of plastic, glass and adhesive, and the second material is selected from the group consisting of metals, ceramics, carbon, and inorganic fibers and sheets.
36. The thermoelectric system of aspect 32, wherein the heat transfer device comprises a continuous body and a plurality of layers on or within the body, wherein the layers extend along the direction generally perpendicular to the direction of working medium flow.
37. The thermoelectric system of aspect 32, wherein the heat transfer device comprises a heterogeneous material.
38. The thermoelectric system of aspect 32, wherein
   the heat transfer device comprising a body of a thermally conductive material having a plurality of elongate slots therethrough, the slots generally perpendicular to a direction of working medium movement, the body having a plurality of folds and a plurality of portions generally parallel to one another and parallel to the direction of working medium movement,
39. The thermoelectric system of aspect 38, wherein the body is a unitary piece of material.
40. The thermoelectric system of aspect 38, wherein at least a portion of the heat transfer device is a wicking agent.
41. The thermoelectric system of aspect 38, wherein at least a portion of the system is in proximity of a wicking agent to allow moisture transfer from the system to the wicking agent.
42. The thermoelectric system of aspect 32, wherein at least a portion of the heat transfer device is a wicking agent.
43. The thermoelectric system of aspect 32, wherein at least a portion of the system is in proximity of a wicking agent to allow moisture transfer from the system to the wicking agent.

### BRIEF DESCRIPTION OF THE DRAWINGS

Figure 1A is a typical TE module with no electrical power applied;

Figure 1B is the TE module illustrated in Figure 1A with electrical power applied showing induced shear stresses on TE elements;

Figure 2 is a typical TE system including a plurality of TE modules as illustrated in Figures 1A and 1B;

Figure 3 is a typical TE system similar to the TE system of Figure 2 that includes a segmented top substrate to form a plurality of sub-modules;

Figure 4A is a side view of the TE system of Figure 2 illustrating the electrical current flow through the TE system;

Figure 4B is a partial cut-away top of the TE system of Figure 2 illustrating the electrical current flow through the TE system;

Figure 5A is a perspective view of an example TE system illustrating the electrical current flow through the TE system in accordance with certain embodiments described herein;

Figure 5B is a side view of the TE system of Figure 5A;

Figure 5C is a front cross-sectional view of the TE system of Figure 5A illustrating the electrical current flow through the TE system;

Figure 6 is a perspective view of an example TE system with a sectioned bottom substrate in accordance with certain embodiments described herein;

Figure 7 is a front cross-sectional view of an example TE system with a substrate between two TE modules in accordance with certain embodiments described herein;

Figure 8A is a perspective view of an example TE system with a sectioned top and bottom substrate in accordance with certain embodiments described herein;

Figure 8B is a front cross-sectional view of the TE system of Figure 8A;

Figure 9A is a side-view of an example TE system with a finned heat transfer structure on the top and bottom and a heat transfer structure between two TE modules illustrating flow of heat transfer fluid in accordance with certain embodiments described herein;

Figure 9B is a perspective view of an example finned heat transfer structure attached to a shunt in accordance with certain embodiments described herein;

Figure 9C is a perspective view of an example finned heat transfer structure integrated with a shunt in accordance with certain embodiments described herein;

Figure 10A is a side view of an example TE system illustrating the electrical current flow through the TE system in accordance with certain embodiments described herein;

Figure 10B is a perspective view of a shunt of Figure 10A;

Figure 10C is a perspective view of the TE system of Figure 10A;

Figure 11 is a perspective view of an example TE system similar to the TE system of Figure 10A that includes segmented shunts in accordance with certain embodiments described herein;

Figure 12 is a perspective view of an example shunt with electrically isolated segments in accordance with certain embodiments described herein;

Figure 13 is a perspective view of an example TE module in accordance with certain embodiments described herein;

Figure 14 is a perspective view of an example TE module with an array of sixty TE modules of Figure 13 in accordance with certain embodiments described herein;

Figure 15 is a plot of voltage as a function of electrical current of the TE module of Figure 14 for different temperature differentials between a cold side fluid inlet temperature and a hot side fluid inlet temperature;

Figure 16 is a plot of electrical power as a function of electrical current of the TE module of Figure 14 for different temperature differentials between a cold side fluid inlet temperature and a hot side fluid inlet temperature;

Figure 17 is a plot of electrical power as a function of hot fluid inlet temperature for different cold fluid inlet temperatures and fluids;

Figure 18A is a perspective view of an example TE system with a stack of ten TE modules of Figure 14 in accordance with certain embodiments described herein;

Figure 18B is a plot of measured electrical power as a function of electrical current of the TE system of Figure 18A with a temperature difference between a hot fluid inlet and a cold fluid inlet of 207°C;

Figure 19 is a perspective view of an example TE module in accordance with certain embodiments described herein;

Figure 20 is a plot of measured values and computer-model calculated values of voltage as a function of electrical current of the TE module of Figure 19 for different hot fluid inlet temperatures;

Figure 21 is a plot of measured values and computer-model calculated values of electrical power as a function of electrical current of the TE module of Figure 19 for different hot fluid inlet temperatures;

Figure 22 is a plot of measured electrical power as a function of thermal cycles for the TE module of Figure 19 where the hot side fluid temperature was cycled between 50°C and 190°C;

Figure 23 is a plot of measured voltage as a function of electrical current of a single layer array of sixty TE modules of Figure 19 for different cold side fluid inlet temperatures and hot side fluid inlet temperatures;

Figure 24 is a plot of measured electrical power as a function of electrical current of a single layer array of sixty TE modules of Figure 19 for different cold side fluid inlet temperatures and hot side fluid inlet temperatures;

Figure 25 is a plot of measured electrical power output and conversion efficiency of a converter as a function of electrical power output of a single layer array of sixty TE modules of Figure 19;

Figure 26A schematically illustrates TE elements electrically connected in series;

Figure 26B schematically illustrates TE elements electrically connected in parallel;

Figure 26C schematically illustrates TE elements electrically connected in series and parallel;

Figure 27 is a top view of an embodiment of a TE system with two TE modules with each having an electrical series of TE elements and the TE modules having select electrical connections between them in accordance with certain embodiments described herein;

Figure 28A is a front cross-sectional view of an example TE system with a TE module on either side of a substrate and the TE modules having at least one electrical connection between them in accordance with certain embodiments described herein;

Figure 28B is a front cross-sectional view of an example TE system with two TE modules on either side of a substrate and the TE modules on the same side of the substrate having at least one electrical connection between them and TE modules on opposite sides having at least one electrical connection between them in accordance with certain embodiments described herein;

Figure 29 is a side view of a conventional TE system illustrating shear stresses induced by differential shrinkage of components of the TE system upon cooling;

Figure 30 is a side view of an example TE system with shunts that include a plurality of layers in accordance with certain embodiments described herein;

Figure 31A is a top view of an example sheet with slots formed within in accordance with certain embodiments described herein; and

Figure 31B is a top view of the example sheet of Figure 31A folded to form a finned heat transfer structure in accordance with certain embodiments described herein.

### DETAILED DESCRIPTION OF THE PREFERRED EMBODIMENT

To reduce TE system cost and improve performance (e.g. for high power density high thermal power designs (e.g. HVAC) and waste heat recovery systems) new solutions are desired. In such designs, the TE elements may be relatively larger in cross sectional area, so that thermally induced stresses are higher within the element itself. The substrate may be replaced by platforms such as extruded tubing, brazed sheet fin structures, etc. In certain applications, the platforms can be made from aluminum or copper to increase performance, to reduce weight and/or cost of manufacture, as well as for other beneficial reasons. However, useful substrate replacement materials such as copper and aluminum have 4-6 times the coefficient of thermal expansion (CTE) of traditional alumina substrates. These designs, plus other configurations related to the desire to improve durability when exposed to shock and vibration, can benefit from new designs that address reduced shear stresses.

Certain embodiments described herein address the detrimental effects of differential thermal expansion. For example, the electric current flow path of a TE module can be reconfigured. Heat transfer structures can also be designed to reduce stresses induced by differential thermal expansion. Any typical thermoelectric material may be used; for example, doped n- and p-type bismuth telluride may be used.

### Thermoelectric Systems with Reduced Thermal Differential-Induced Stresses

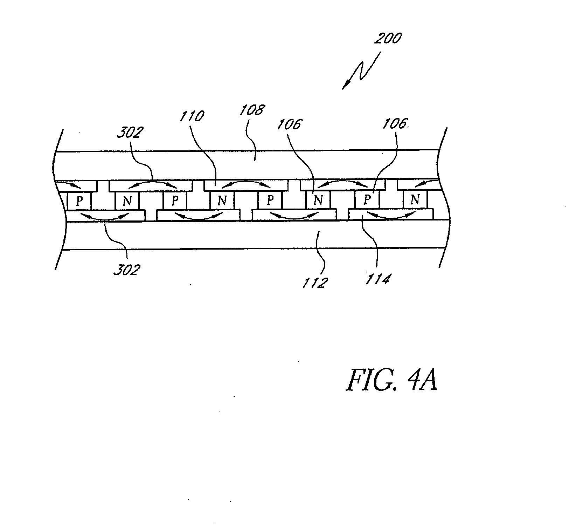

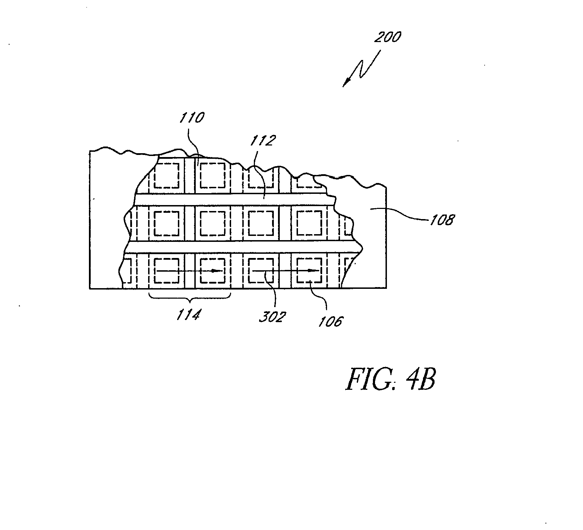

Typically, conventional TE modules 200 have electrical current flowing generally in one direction. Figure 4A illustrates a side view of the conventional TE module 200 of Figure 2. For example, the electrical current path 302 is illustrated in Figure 4A to flow from the left to the right. The electrical current flow path 302 is serpentine in a plane generally perpendicular to the top substrate 108 and bottom substrate 112 and generally parallel to the row of TE elements 106. However, the electrical current flow path 302 is substantially linear in a plane generally parallel to the top substrate 108 and bottom substrate 112, as illustrated by a partial cut-away top view in Figure 4B.

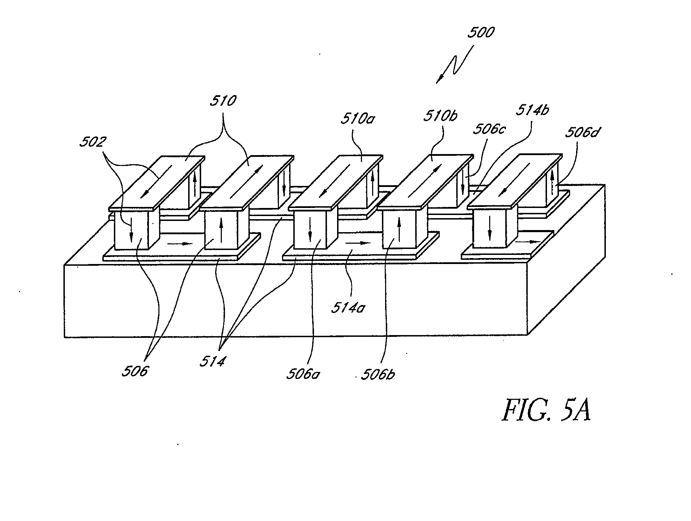

In contrast, in certain embodiments, the current flow path 302 is serpentine in at least two planes. Figure 5A illustrates a perspective view of an example TE system 500 comprising at least one cell, wherein the current flow path 502 is serpentine in at least two planes. A cell can include a plurality of TE elements and a plurality of electrically conductive shunts operatively coupled together. One or more cells can be put in electrical communication with one or more other cells to form a TE system. For example, a plurality of cells can be put in electrical series and/or parallel communication with one another to form the TE system.

In certain embodiments, a first plurality of electrically conductive shunts 514 extend along a first direction, and a second plurality of electrically conductive shunts 510 extend along a second direction non-parallel to the first direction. In certain embodiments, the first plurality of electrically conductive shunts 510 and the second plurality of electrically conductive shunts 514 are substantially perpendicular to each other. The first plurality of shunts 514 can be arranged into two rows that are substantially parallel to one another. Similarly, the second plurality of shunts 514 can be arranged into two rows that are substantially parallel to one another. For example, the thermoelectric materials can be suitably doped n- and p-type bismuth telluride, about 2 mm long (in the direction of current flow), and about 3 mm by 3 mm in the other dimensions resulting in a cross sectional area of about 9 mm². Alternately, the TE elements 506 can be longer and made from segments of lead telluride for portions exposed to temperatures between about 250°C and 500°C, and bismuth telluride for temperatures up to about 250°C.

In certain embodiments, the TE system includes a cell with a first plurality of TE elements 506 that are in electrical communication with the first plurality of electrically conductive shunts 510 and second plurality of electrically conductive shunts 514. In certain embodiments, a first TE element 506a is between and in electrical communication with a first shunt 510a of the first plurality of shunts 510 and a second shunt 514a of the second plurality of shunts 514. A second TE element 506b is between and in electrical communication with the second shunt 514a and a third shunt 510b of the first plurality of shunts 510. A third TE element 506c is between and in electrical communication with the third shunt 510b and a fourth shunt 514b of the second plurality of shunts 514. The current flows 502 substantially parallel to the first direction through the first shunt 510a, through the first TE element 506a, substantially parallel to the second direction through the second shunt 514a, through the second TE element 506b, substantially parallel to the first direction through the third shunt 510b, through the third TE element 506c, and substantially parallel to the second direction through the fourth shunt 514b. In certain embodiments, the cell further includes a fourth TE element 506d in electrical communication with the fourth shunt 514b, wherein the current flows through the fourth TE element 506d.

In certain embodiments, the current flow path 302 can be serpentine in two planes generally perpendicular to a first substrate 508 and/or a second substrate 512, as illustrated in Figures 5A-C. In certain embodiments, the first substrate 508 is a top substrate and the second substrate 512 is a bottom substrate. For example, the current flows 502 through the first shunt 510a and the third shunt 510b in substantially parallel directions to one another and the current flows 502 through the second shunt 514a and the fourth shunt 514b in substantially antiparallel directions to one another.

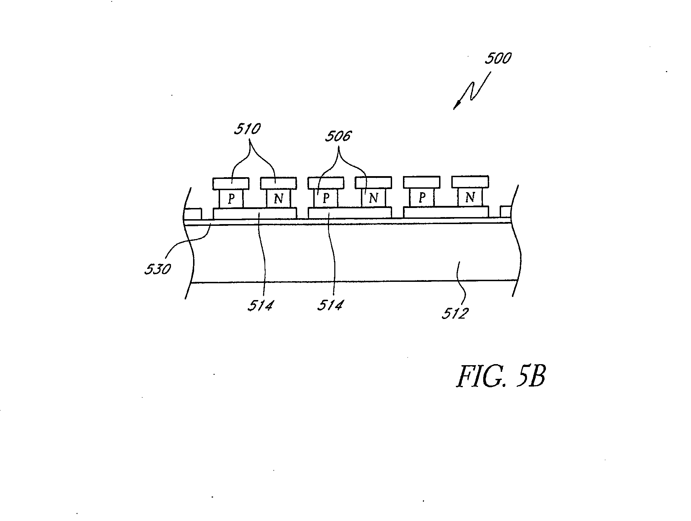

The TE module 500 illustrated in Figures 5A-C can have an improved durability to thermal gradients as compared to a conventional TE module 200. The first shunts 510 are able to move substantially independently from one another so as to induce minimal shear stress in a direction in the plane of the first shunts 510 and perpendicular to the length of the first shunts 510 (e.g. in a direction perpendicular to the direction of the current flow or in the left-right directions in Figure 5B). Each first shunt 510 can act like a submodule 304 of Figure 3. If the second substrate 512 is a relatively large surface, differential thermal expansion can still be a factor in the direction of the length of the first shunts 510. Conversely, if the first substrate 508 is a relatively large surface, differential thermal expansion can still be a factor in the direction of the length of the second shunts 514. This can be a severe problem if the length of the first shunts 510 or the distance between TE elements 506 is over several millimeters and the substrate has a relatively high CTE (e.g. aluminum or copper). If the CTE is 4-6 times that of alumina, even short lengths of the first shunts 510 or distances between TE elements 506 can result in high stresses induced by thermal differentials. The stresses can be even larger if the TE module 500 operates in both heating and cooling modes, the first shunt 510 material and the second substrate 512 material have substantially different CTEs, or the TE module 500 is used with a power generator with large temperature differentials (e.g. up to 1,000°C).

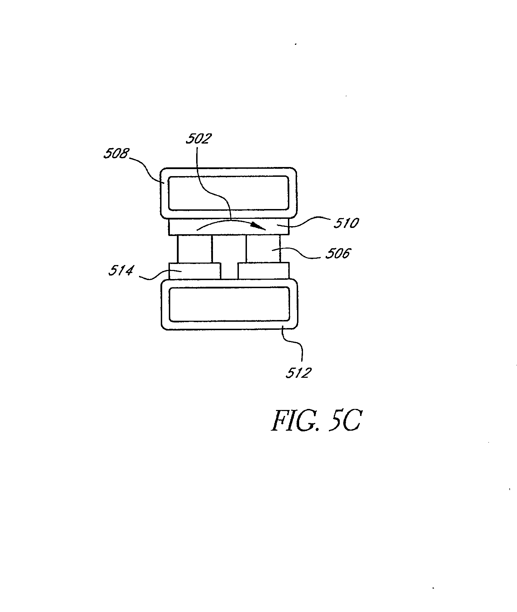

The first shunts 510 can be thermally connected to the first substrate 508, and the second shunts 514 can be thermally connected to the second substrate 512. For example, the first shunt 510a and the third shunt 510b can be in thermal communication with the first substrate 508, and the second shunt 514a and the fourth shunt 514b can be in thermal communication with the second substrate 512. In certain other embodiments, an electrically insulative layer 530 can be placed between the first shunts 510 and the first substrate 508 and/or between the second shunts 514 and the second substrate 512, as illustrated in Figure 5B. The first substrate 508 and the second substrate 512 can include heat exchangers or can be thermally coupled to heat exchangers. The heat exchangers can be configured to allow a working medium (e.g. heat transfer fluid) to flow through and be in thermal communication with the heat exchanger. In certain embodiments, at least one heat exchanger is in thermal communication with at least some of the TE elements. The heat exchanger can be, for example, a tube that transports a heat transfer fluid, as illustrated in Figure 5C. In certain embodiments, the working medium flows in a direction substantially parallel to a direction along which the first shunts 510 extend. In certain other embodiments, the working medium flows in a direction substantially perpendicular to the direction along which the first shunts 510 extend. In certain embodiments, the working medium flows in a direction substantially parallel to the first direction. In certain other embodiments, at least some of the working medium flows in a direction substantially parallel to the second direction.

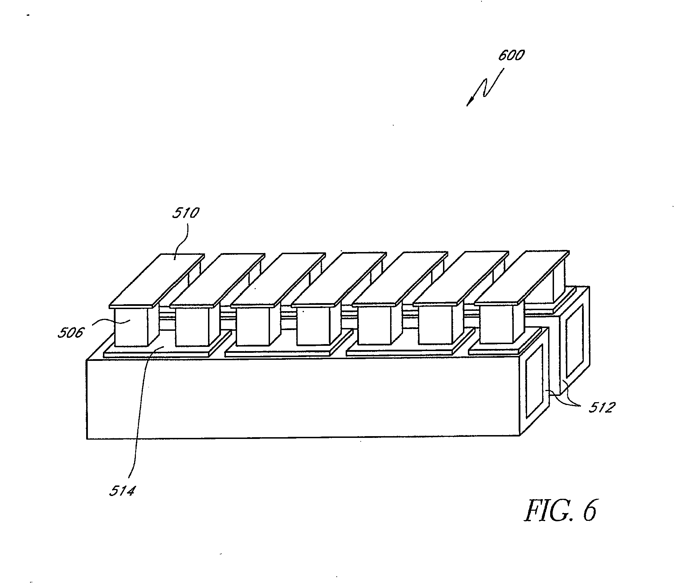

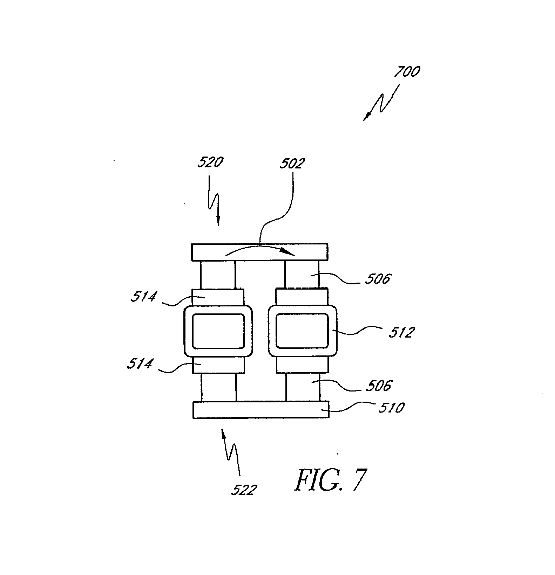

In certain embodiment, the second substrate 512 is separated into two or more segments. For example, as illustrated in Figure 6, the TE module 600 includes a second substrate 512 including two segments extending generally along the lengths of the second shunts 514 (e.g. direction of current flow in the second shunts 514) and separated from one another in a direction substantially along the length of the first shunts 510 (e.g. direction of current flow in the first shunts 510). In certain embodiments, the TE elements 506 of the first plurality of TE elements are arranged in a first row and a second row substantially parallel to one another, with the first TE element 506a and the second TE element 506b in the first row and the third TE element 506c and the fourth TE element 506d in the second row. In certain embodiments, each row of second shunts 514 contacts one segment of the second substrate 512 and does not contact and another segment of the second substrate 512 (e.g. directly or with an electrically insulative layer therebetween). In certain embodiments, each segment of the lower substrate 512 is at least one heat exchanger. In certain embodiments, the at least one heat exchanger comprises a first heat exchanger in thermal communication at least some of with the first row of TE elements 506 and a second heat exchanger in thermal communication with at least some of the second row of TE elements 506. In certain embodiments, the TE module 700 has a first TE assembly 520 in thermal communication with one side of the second substrate 512 and a second TE assembly 522 in thermal communication with the opposite side of the second substrate 512, as illustrated in Figure 7.

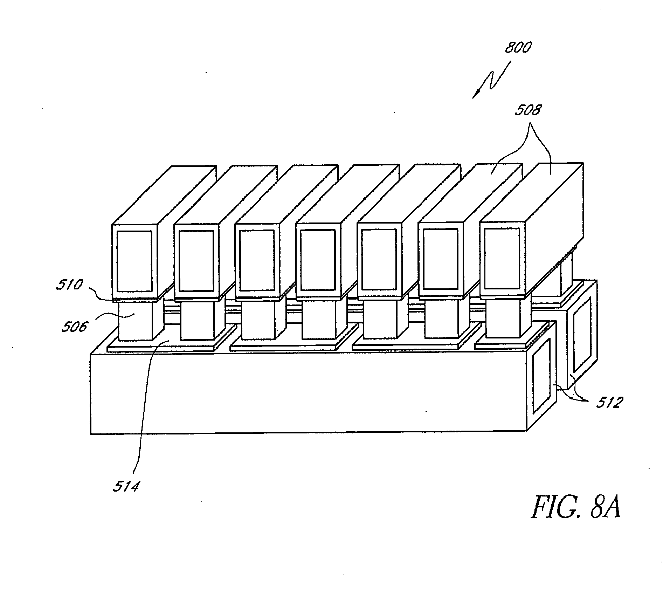

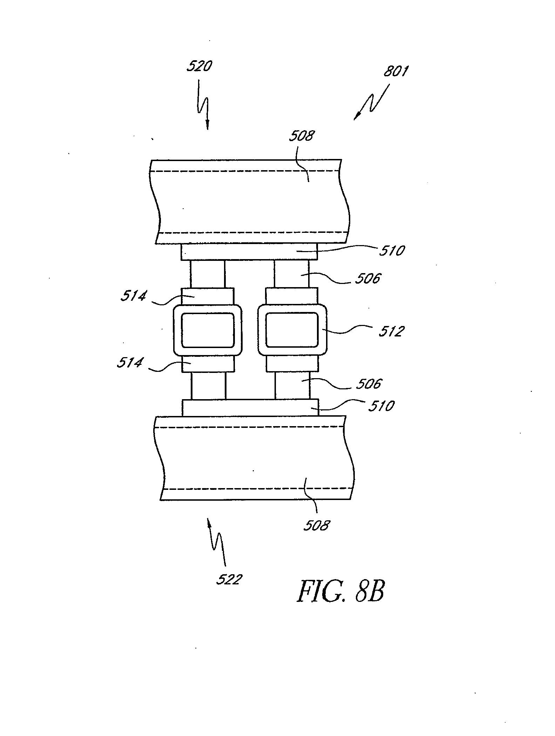

As illustrated in Figure 8A, the first substrate 508 can also be separated into two or more segments. In a manner similar to that of the segments of the second substrate 512, the segments of the first substrate 508 extend generally along the length of the first shunts 510 (e.g. direction of current flow in the first shunts 510) and are separated from one another in a direction substantially along the length of the second shunts 512 (e.g. direction of current flow in the first shunts 508). In certain embodiments, each first shunt 510 contacts at least one segment of the first substrate 508 and does not contact another segment of the first substrate 508 (e.g. directly or with an electrically insulative layer therebetween). In certain embodiments, a first TE assembly 520 is in thermal communication with one side of the second substrate 512 and a second TE assembly 522 is the opposite side of the second substrate 512, as illustrated in Figure 8B.

In certain embodiments, the thermoelectric system comprises a first heat exchanger with a first side and a second side and a second heat exchanger with a first side and a second side. The first side of the first heat exchanger is in thermal communication with at least some of a first row of TE elements, and the first side of the second heat exchanger is in thermal communication with at least some of a second row of TE elements. In certain such embodiments, the thermoelectric system further comprises a third plurality of electrically conductive shunts extending along the first direction and in thermal communication with at least one of the second side of the first heat exchanger and the second side of the second heat exchanger, a fourth plurality of electrically conductive shunts extending along the second direction, and a second plurality of TE elements. The second plurality of TE elements comprises a fourth TE element between and in electrical communication with a fifth shunt of the third plurality of shunts and a sixth shunt of the fourth plurality of shunts, a fifth TE element between and in electrical communication with the sixth shunt and a seventh shunt of the third plurality of shunts, and a sixth TE element between and in electrical communication with the seventh shunt and an eighth shunt of the fourth plurality of shunts. In certain such embodiments, current flows substantially parallel to the first direction through the fifth shunt, through the fourth TE element, substantially parallel to the second direction through the sixth shunt, through the fifth TE element, substantially parallel to the first direction through the seventh shunt, through the sixth TE element, and substantially parallel to the second direction through the eighth shunt.

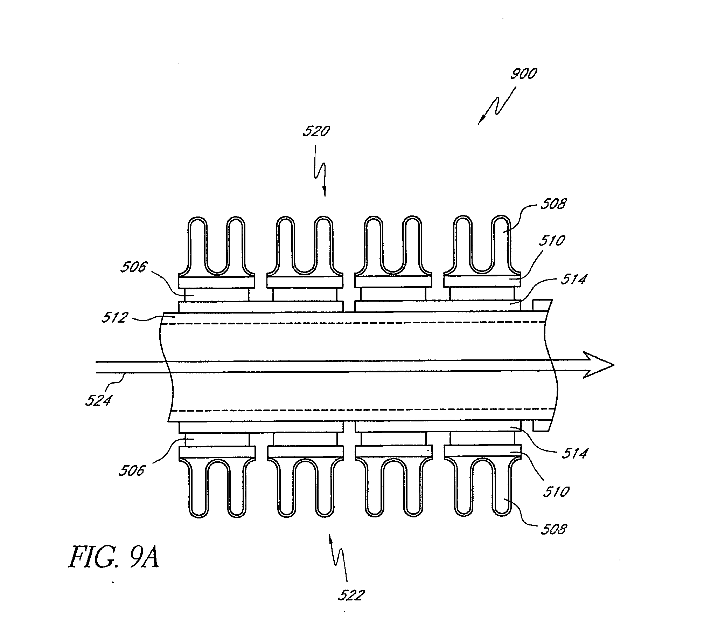

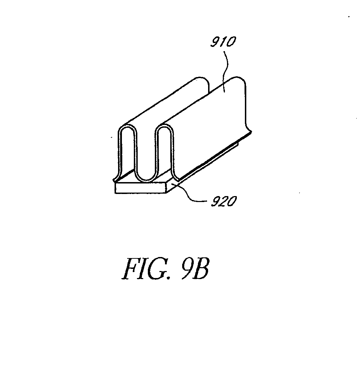

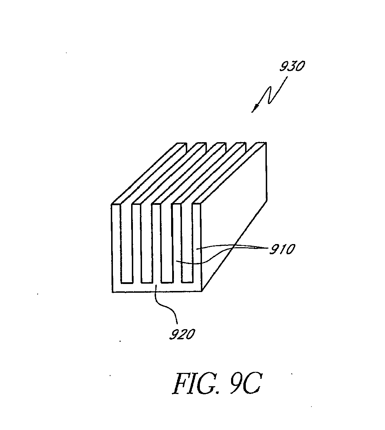

In certain embodiments, the heat transfer fluid is liquid, gas or slurry. The working medium 524 can flow through a heat exchanger such as the second substrate 512, as illustrated in Figure 9A. In certain embodiments, the first substrate 508 can be an air heat exchanger (e.g. louvered fins, off-set fins), as illustrated in Figures 9A-C. In certain embodiments, the air heat exchangers are configured for air flow in a direction substantially perpendicular to the direction of flow of the working medium 524 through the second substrate 512, as illustrated in Figure 9A. In certain other embodiments, the air heat exchangers are configured for air flow in a direction substantially parallel to the direction of flow of the working medium 524 through the second substrate 512. Figure 9B illustrates an example fin-type heat exchanger 910 attached to a shunt 920. Figure 9C illustrates an example fin-type heat exchanger 910 and a shunt 920 as an integral shunt-heat exchanger component 930.

In certain embodiments, the heat exchanger have relatively good thermally conductive contact with the shunts. For example, the heat exchanger can be attached to the shunts by a thermally conductive material (e.g. thermal grease). In certain embodiments, the heat exchanger is not in electrical communication with the shunts (e.g. the heat exchanger is electrically isolated from the shunts). Similar criteria apply to the design of any additional TE assemblies that may be stacked vertically and/or horizontally together to form a complete device.

In certain embodiments, the TE module is configured to prevent the TE circuitry (e.g. the shunts) from shorting with a electrically conductive heat exchanger material. Electrical isolation between the shunts and the heat exchanger material while maintaining relatively good thermal transport properties can be achieved by a number of configurations including: anodized fins, shunts and extruded tubing; non-conductive epoxy (e.g. with imbedded glass balls, non-electrically conductive matting, or any other method of providing spacing to provide electrical isolation); heat exchanger segments attached to a single shunt that utilize non-electrically conductive gas as the heat transfer medium, as depicted in Figures 9A-C; or any other suitable configuration. In certain embodiments, a non-electrically conducting layer is placed between the heat exchanger and shunts. For example, if the heat exchanger is aluminum, it can be anodized to create a non-electrically conducting layer between the heat exchanger and shunts. Other types of coatings can also be provided such as aluminum nitride, other thermally conductive ceramics, fiberglass filled epoxy adhesives, mats constructed of high thermal conductivity and non-electrically conductive webbing and greases, and any other high thermally conductive, electrically nonconductive barriers. The non-electrically conductive barrier layer may also include other desirable properties such as mechanical strength, abrasion resistance, low interfacial friction and corrosion protection.

### Thermoelectric Systems with a Stacked Thermoelectric Element Configuration

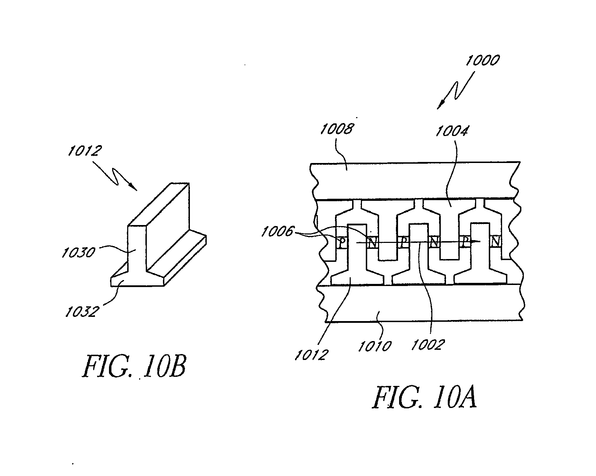

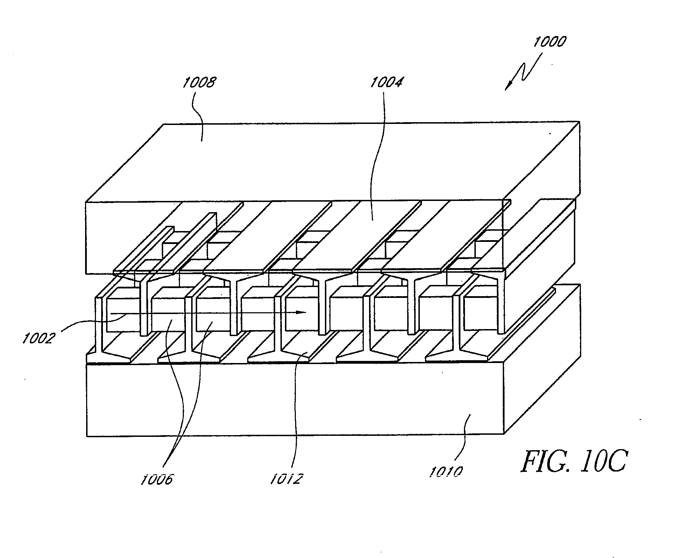

Examples of thermoelectric system configurations are described in U.S. Patent Number 6,959,555, herein incorporated by reference. Figure 10A illustrates a TE module 1000 with multiple TE elements 1006 stacked in the direction of current flow 1012. Each TE element 1006 is adjacent to a first heat transfer structure 1004 and to a second heat transfer structure 1012 such that the TE element 1006 is sandwiched between the first heat transfer structure 1004 and the second heat transfer structure 1012. The first heat transfer structure 1004 and the second heat transfer structure 1012 can be shunts in thermal communication with a first heat exchanger 1008 and a second heat exchanger 1010, respectively. In certain embodiments, a thermally conductive and electrically insulative material is between the first heat transfer structure 1004 and the first heat exchanger 1008, and between the second heat transfer structure 1012 and the second heat exchanger 1010. For example, aluminum nitride can be used as the thermally conductive and electrically insulative material. The thermally conductive and electrically insulative material can prevent electrical communication between the first heat transfer structure 1004 and the first heat exchanger 1008, and between the second heat transfer structure 1012 and the second heat exchanger 1010. The TE elements 1006, the first heat transfer structures 1004 and the second heat transfer structures 1012 form a stack. In certain embodiments, the TE elements 1006 of the stack are in series electrical communication with one another. Stresses are induced by the attachment of the TE elements 1006 to the first heat transfer structure 1004 and to the second heat transfer structure 1012. However, unlike the conventional TE system 100 illustrated in Figure 1B, no shear forces are induced between adjacent TE elements 1006. In certain embodiments, the first heat transfer structure 1004 and the second heat transfer structure 1012 are each adjacent to a plurality of p-type TE elements and a plurality of n-type TE elements, as illustrated in Figure 10C. The TE elements 1006 sandwiched between a first heat transfer structure 1004 and a second heat transfer structure 1012 are spaced from one another in a direction generally perpendicular to the direction of current flow through the first heat transfer structure 1004, the second heat transfer structure 1012, and/or the TE elements 1006.

The first heat transfer structure 1004 and the second heat transfer structure 1012 has a first portion 1030 and a second portion 1032, as illustrated in Figure 10B. The first portion 1030 of certain embodiments has at least one surface extending along a direction generally perpendicular to the direction of current flow through the first portion 1030 and configured to be in thermal communication with a plurality of TE elements. The second portion 1032 of the first heat transfer structure 1004 projects away from the stack in a first direction and the second portion 1032 of the second heat transfer structure 1012 projects away from the stack in a second direction. In certain embodiments, the first direction and the second direction are generally opposite to one another. The second portion 1032 of the first heat transfer structure 1004 can in thermal communication with a first heat exchanger 1008 and/or first working medium and the second portion 1032 of the second heat transfer structure 1012 can be in thermal communication with a second heat exchanger 1010 and/or second working medium. In certain embodiments, the second portion 1032 is larger than the first portion 1030. For example, the second portion 1032 can have a larger cross-sectional area in a plane substantially perpendicular to the first direction and/or the second direction than the first portion 1030, or the second portion 1032 can have a larger dimension in substantially the direction of the electrical current flow 1002. In certain embodiments, the heat transfer structures 1014 are generally T-shaped.

Figure 10C illustrates a perspective view of the TE module 1000 in Figure 10A. A plurality of TE elements 1006 are between the first heat transfer structure 1004 and the second heat transfer structure 1012. For example, a first plurality of TE elements 1006 can be sandwiched between the first portion 1030 of a first heat transfer structure 1004 and the first portion 1030 of a second heat transfer structure 1012, and a second plurality of TE elements 1006 can be sandwiched between the first portion 1030 of a third heat transfer structure 1004 and the first portion 1030 of the second heat transfer structure 1012. In certain embodiments, the first plurality of TE elements are in parallel electrical communication with one another and the second plurality of TE elements are in parallel electrical communication with one another.

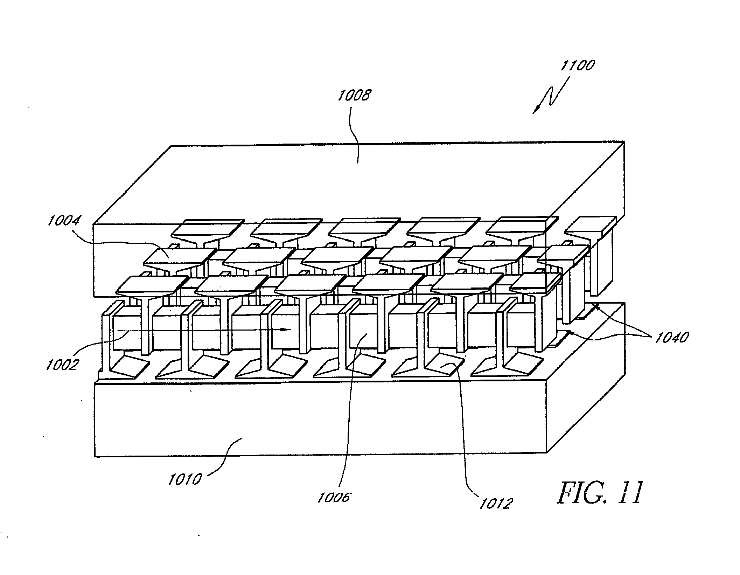

The first heat transfer structure 1004 and/or the second heat transfer structure 1012 can be a plurality of thermally conductive segments spaced from one another in a direction generally perpendicular to the direction of the electrical current 1012, as illustrated in Figure 11. Each thermally conductive segment can be in thermal communication with at least one TE element 1006. The gaps or spaces 1040 between the thermally conductive segments reduces temperature differential-induced stresses since the gaps 1040 allow each thermally conductive segment in thermal communication with a first heat exchanger 1008 to expand and contract independently from one another and/or from the thermally conductive segments in thermal communication with a second heat exchanger 1010. Thus, the TE module 1000 has redundancy and ruggedness of multiple parallel TE elements 1006.

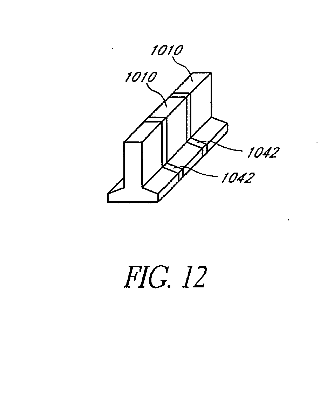

In certain embodiments, the neighboring thermally conductive segments of the heat transfer structure are mechanically connected to each other and are electrically isolated from one another. In certain embodiments, the heat transfer structure includes one or more electrically insulative spacers 1042 between the thermally conductive segments, as illustrated in Figure 12. The spacers 1042 can add mechanical rigidity to the TE module 1000. The spacer 1042 can be a material that is relatively strong and chemically stable. In certain embodiments, the spacer is relatively flexible. In other embodiments, the spacer is relatively rigid. The spacer can include epoxies, polymers, glasses, ceramics, etc. The insulative spacers electrically isolate electrical circuits including TE elements and thermally conductive segments in series electrical communication with one another. In certain embodiments, the electrical circuits are electrically isolated from one another in a direction generally parallel to the direction of electrical current flow. For example, the direction of electrical current flow in one electrical circuit can be generally opposite to a neighboring electrical circuit. Since the voltage output of a TE generator is approximately proportional to the number of TE elements in electrical series connection, the arrangement in Figure 11 has a higher voltage output (and having an approximately proportionally lower current output) than a device of the same size and number of TE elements that are connected in parallel.

The stack of certain embodiments can include a material having a lower elastic modulus than the TE elements 1006. For example, the material can be sandwiched between at least one first portion 1030 of the heat transfer structure and a neighboring TE element within the stack. The material can effectively reduce the strain and stress on the TE elements 1006 during operation of a TE system Temperature difference between the first heat transfer structure 1004 and the second heat transfer structure 1012 can create strain and stresses (e.g. compressive and/or tensile) within stack. If a material is sandwiched within the stack that has a lower elastic modulus than the TE elements 1006, the material will deform more than the TE elements 1006 and the strain and stress on the TE elements 1006 will be lower. By reducing the strain and stress on the TE elements 1006, the mechanical failure of the TE elements 1006 can be reduced. The TE system 1000 can include a support structure that holds the stack under compressive force in a direction generally along the stack. For example, the compressive force can be applied by screws, springs, etc. Typically, TE elements 1006 can have a larger compressive stress applied to them than a tensile stress before mechanical failure of the TE elements 1006. By applying a compressive force to the stack, tensile stresses acting on TE elements 1006 can be reduced, and therefore, the mechanical failure of the TE elements 1006 can be reduced.

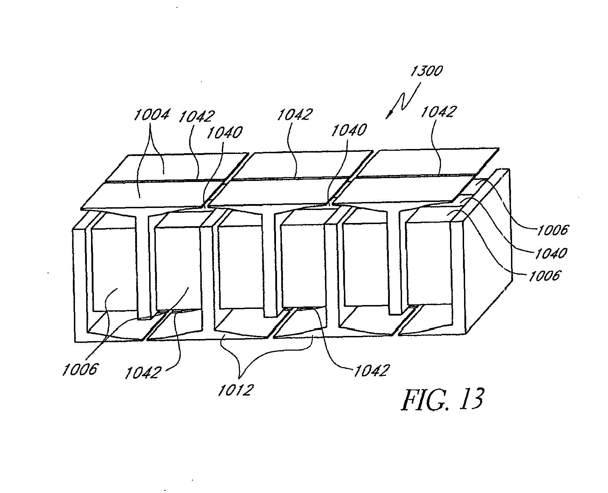

One or more TE modules can be put in electrical communication with one or more additional TE modules to form a TE system. For example, the TE module 1300 illustrated in Figure 13 has a stack of TE elements 1006, first heat transfer structures 1004 and second heat transfer structures 1012. In the example stack of Figure 13, each plurality of TE elements 1006 sandwiched between a first heat transfer structure 1004 and a second heat transfer structure 1012 includes two TE elements 1006 and is in thermal communication with the first heat transfer structure 1004 and the second heat transfer structure 1012. The two TE elements 1006 sandwiched between the first heat transfer structure 1004 and the second heat transfer structure 1012 are separated by a gap 1040. In the example stack of Figure 13, the first heat transfer structures 1004 and the second heat transfer structures 1012 are sectioned into two pieces; however, the second heat transfer structures 1012 at either end of the TE module 1300 are not sectioned into two pieces. The sectioning of the first heat transfer structures 1004 and the second heat transfer structures 1012 provides a gap 1044 for thermal expansion of the first heat transfer structures 1004 and the second heat transfer structures 1012.

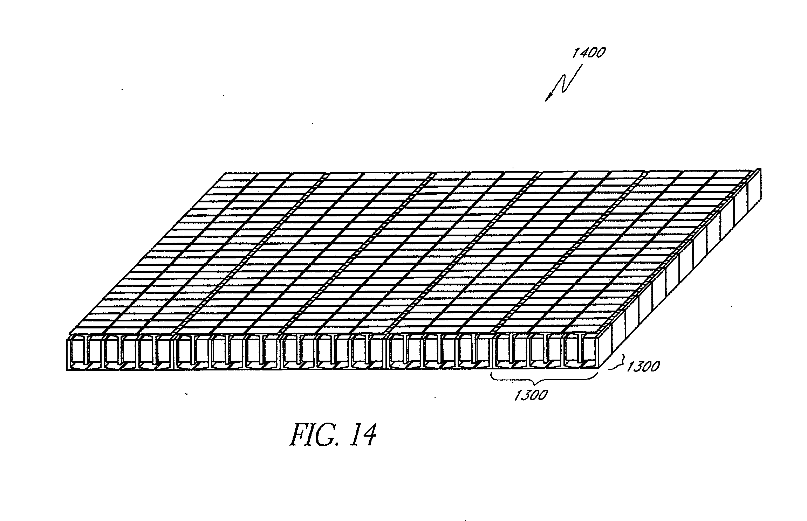

The TE module 1300 illustrated in Figure 13 can be electrically connected with other similar TE modules 1300 to form a TE system. For example, Figure 14 illustrates a TE system 1400 with an array of sixty TE modules 1300 illustrated in Figure 13. There are twelve rows in electrical communication with one another, and each row has five TE modules in serial electrical communication with one another. The twelve rows are in series electrical communication. For example, a first row can have a electrical current flow direction substantially opposite to a second row, a third row can have a electrical current flow direction substantially parallel with the first row, and the second row is between the first row and the third row. However, rows can also be in parallel electrical communication or a mix of series and parallel electrical communication. For example, a first pair of adjacent rows can be in parallel electrical communication with one another, and a second pair of adjacent rows can be in parallel electrical communication with one another. The first pair of adjacent rows can be adjacent to and in series electrical communication with the second pair of adjacent rows. A pair of rows can be in parallel electrical communication with one another by electrically connecting the two rows with an electrically conductive shunt. In certain embodiments, an electrically and/or thermally insulative material is positioned between one or more of the rows. For example, caitian, mylar, mica, fiber glass, etc. can be placed between the rows.

Certain embodiments include a first heat exchanger in thermal communication with the first heat transfer structures 1004, and a second heat exchanger in thermal communication with the second heat transfer structures 1012. The TE system 1400 is considered a single layer device since the TE system 1400 has a single layer array of TE modules 1300. In certain embodiments, the two or more TE systems 1400 can be stacked to form a multi-layer device. For example, the first heat transfer structures 1004 or the second heat transfer structures 1012 of a first TE system 1400 can be put in thermal communication with the first heat transfer structures 1004 or the second heat transfer structures 1012 of a second TE system 1400 to form a two layer device. In certain embodiments, a heat exchanger can be sandwiched between the first TE system 1400 and the second TE system 1400. In certain embodiments, a thermally conductive and electrically insulative material is between the first heat transfer structure 1004 and the first heat exchanger, and between the second heat transfer structure 1012 and the second heat exchanger. For example, aluminum nitride can be used as the thermally conductive and electrically insulative material. The thermally conductive and electrically insulative material can prevent electrical communication between the first heat transfer structure 1004 and the first heat exchanger, and between the second heat transfer structure 1012 and the second heat exchanger.

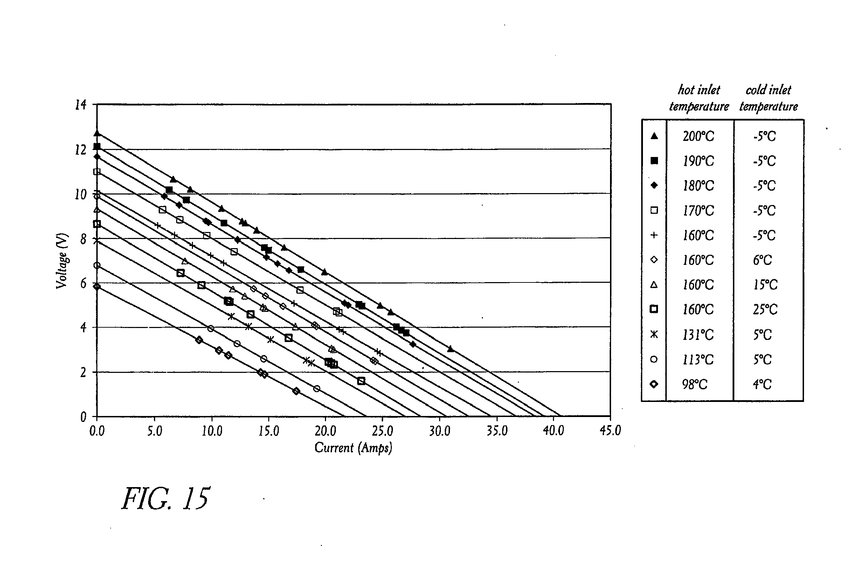

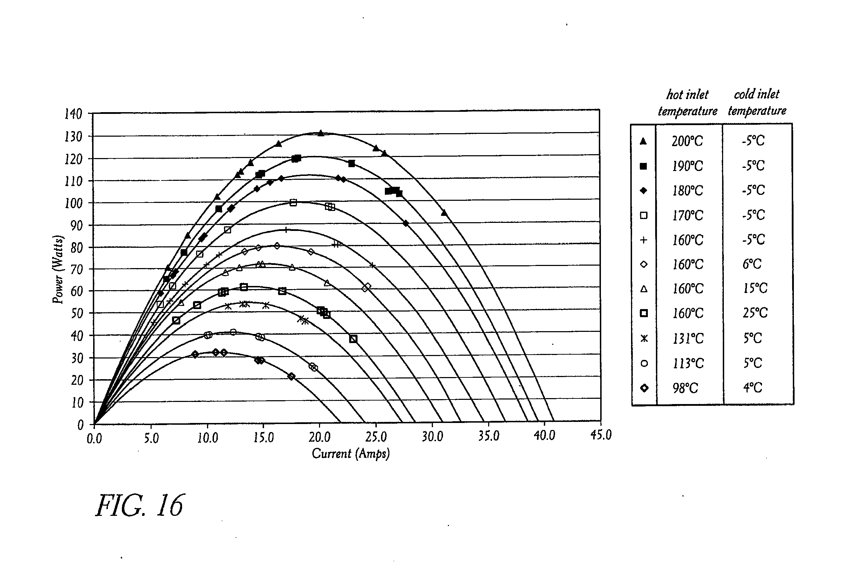

The performance of a TE system 1400 configured as illustrated in Figure 14 was tested with a first heat exchanger on a first side and a second heat exchanger on a second side. A relatively cold fluid flowed through one of the heat exchangers and a relatively hot fluid flowed through the other heat exchanger to maintain a temperature differential between the first and second sides. Cold side inlet temperatures ranged from - 5°C to 25°C. Hot side inlet temperatures ranged from 98°C to 200°C with a maximum temperature difference between the hot and cold inlet temperatures of 205°C. At the maximum temperature difference, Figure 15 illustrates an open circuit voltage greater than 12V. Maximum power output for this condition is illustrated in Figure 16 at 130W. The cold fluid for the measurements of Figures 14-16 was a 50/50 water/ethylene glycol mixture while the hot fluid was organic oil. Doped n- and p-type bismuth telluride were used for the TE elements 1006. Other thermoelectric materials could have also been used.

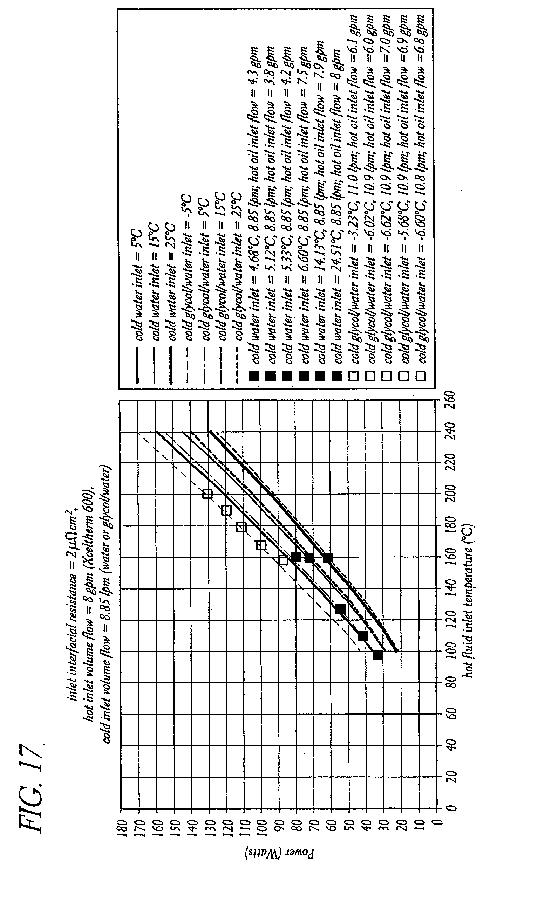

Figure 17 illustrates the peak power results for a TE system 1400 configured as illustrated in Figure 14 as a function of hot fluid inlet temperature. Cold side fluid was water in some tests and 50/50 water/ethylene glycol in other tests. Also illustrated in Figure 17 are calculated or simulated data for the same conditions. The measured data points vary from the simulated curves by less than 10% for a wide range of hot and cold side inlet temperatures. The simulated data was generated using a model described in Crane, D. T. et al., "Modeling the Building Blocks of a 10% Efficient Segmented Thermoelectric Power Generator," International Conference on Thermoelectrics, Corvallis, OR (2008) and integrated with heat exchanger models. The simulation included a series of energy balance equations which were solved in a manner similar to that described in a paper on modeling thermoelectric heating and cooling (*see, e.g.,* Crane, D. T., "Modeling High-Power Density Thermoelectric Assemblies Which Use Thermal Isolation," 23rd International Conference on Thermoelectrics, Adelaide, AU (2004)).

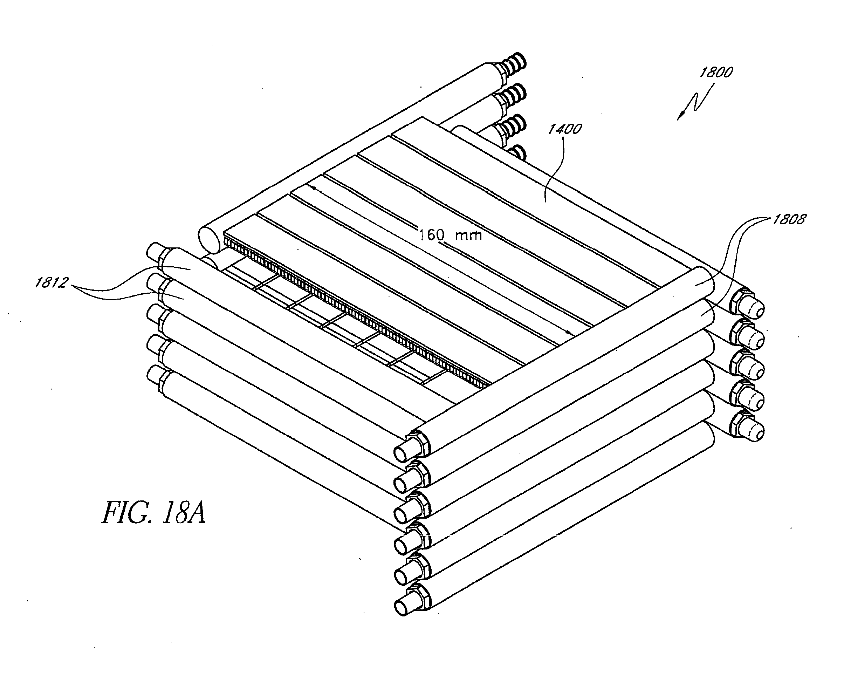

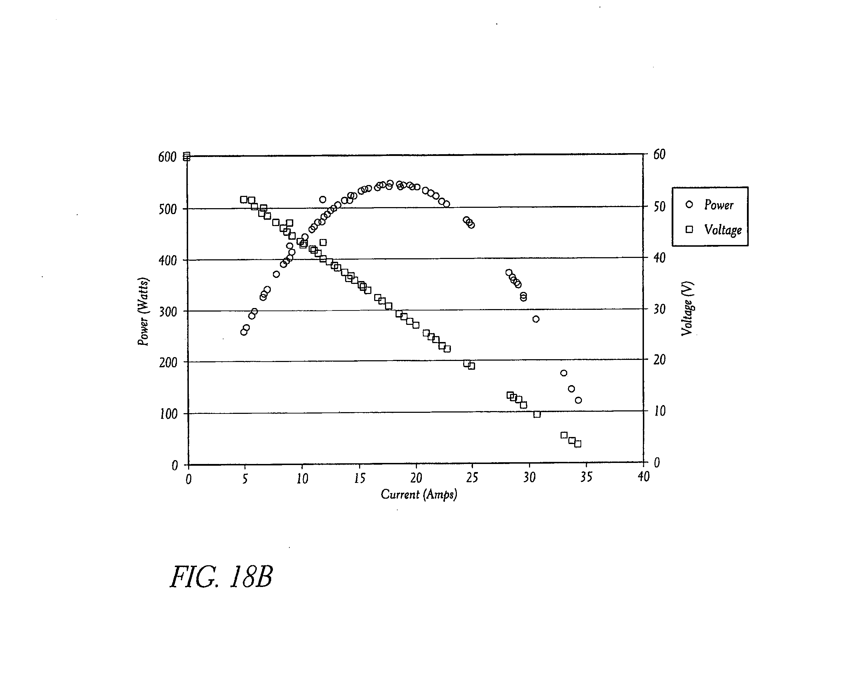

Figure 18A illustrates a TE system 1800 that has ten TE systems 1400 stacked with five hot-fluid heat exchangers 1812 and six cold-fluid heat exchangers 1808. (As used herein, the terms "hot" and "cold" refer to the relative temperature of the fluids flowing through the heat exchangers.) Each TE system 1400 is sandwiched between a hot-fluid heat exchanger 1812 and a cold-fluid heat exchanger 1808. Figure 18B illustrates the performance results of the TE system 1800 of Figure 18A. The temperature difference between the cold inlet temperature and the hot inlet temperature was-207°C. The TE system 1800 had an open circuit voltage greater than 50V and a peak power output greater than 500W. The hot-fluid heat exchangers 1812 were in parallel fluid communication with one another. Similarly, the cold-fluid heat exchangers 1808 were in parallel fluid communication with one another.

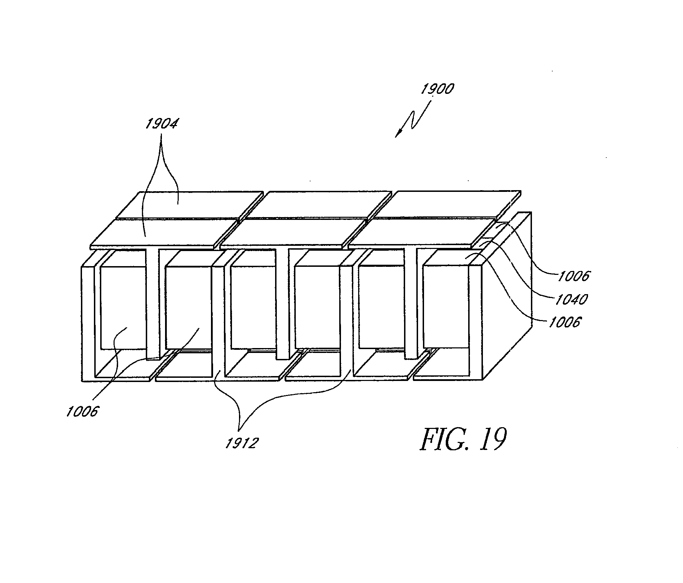

Figure 19 illustrates a TE module 1900 with first heat transfer structures 1904 and second heat transfer structures 1912. These heat transfer structures 1904, 1912 have a reduced volume compared to the first heat transfer structures 1004 and the second heat transfer structures 1012 of the TE module 1300 of Figure 13. The second portion of each heat transfer structure 1904, 1912 has a reduced thickness compared to the heat transfer structures 1004, 1012 of the TE module 1300 of Figure 13. For example, if the same amount of TE material is used in the TE module 1900 of Figure 19 as in the TE module 1300 of Figure 13 and copper is used for the heat transfer structures, the TE module 1300 of Figure 13 weighs 9.88g while the TE module 1900 of Figure 19 weighs 5.72g.

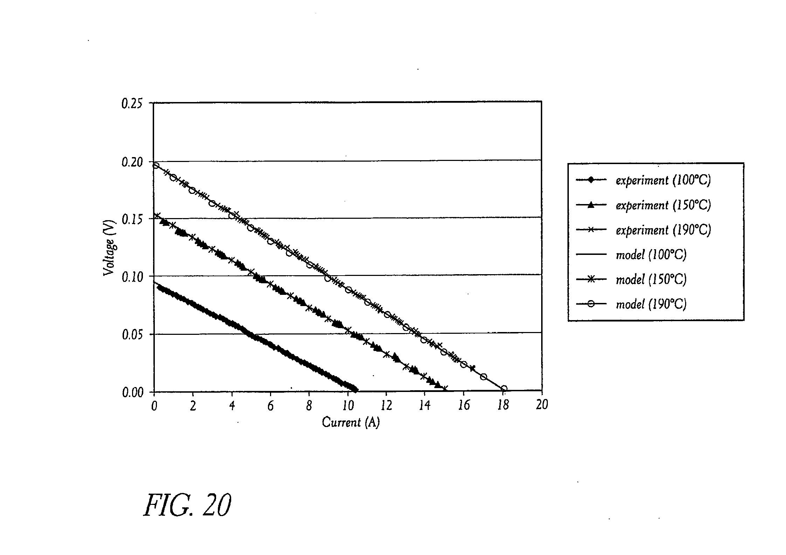

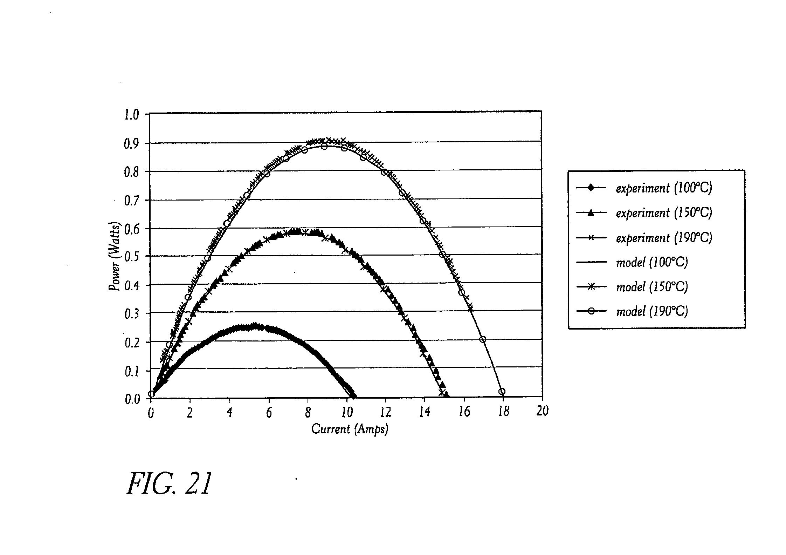

Performance of the TE module 1900 of Figure 19 was tested. Voltage and power are illustrated as a function of current at hot side temperatures of 100°C, 150°C, and 190°C in Figure 20 and 21, respectively. The cold side water bath temperature was 20°C. Figures 20 and 21 also illustrate simulated modeling data for the TE module 1900. Simulated modeling data differs from measured data by less than 5% for each hot side temperature over a current range of 0 to 20A. The electrical interfacial resistance was used as a fitting factor in the simulated modeling data. The calculated electrical interfacial resistance for this particular subassembly was 5.5 µΩcm². This estimated electrical interfacial resistance can be compared to those described in Nolas, G. S. et al., Thermoelectrics - Basic Principles and New Materials Developments. Springer-Verlag (Berlin Heidelberg, 2001). Electrical interfacial resistances less than 10 µΩcm² are considered to be reasonable. This model is described in further detail in Crane, D. T. et al., "Modeling the Building Blocks of a 10% Efficient Segmented Thermoelectric Power Generator," International Conference on Thermoelectrics, Corvallis, OR (2008).

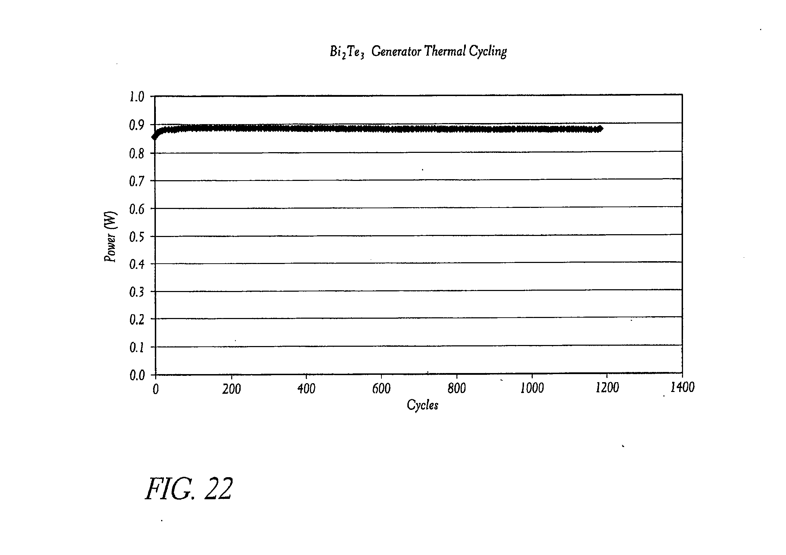

Figure 22 illustrates test results from thermally cycling the TE module 1900 of Figure 19. This test involves fixing the electrical load on the subassembly as well as fixing the temperature of the cold side 50/50 water/ethylene glycol bath at 20°C. The hot side temperature is then cycled between 50°C and 190°C. The graph reflects the peak power output of each of these cycles. As illustrated by Figure 22, the peak power output remained constant for at least 1181 cycles. Although, a TE module in use may experience an amount of thermal cycles on an order of magnitude or two higher than in this test, the TE module 1900 tested shows robustness to thermal cycling.

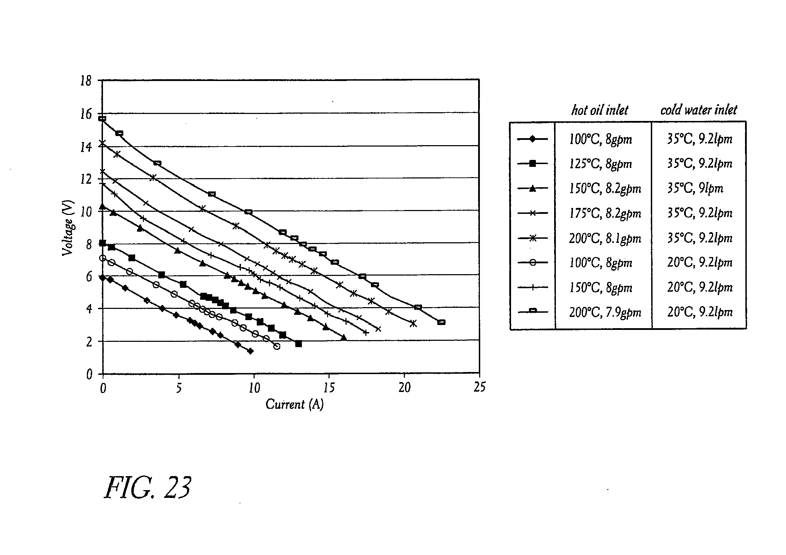

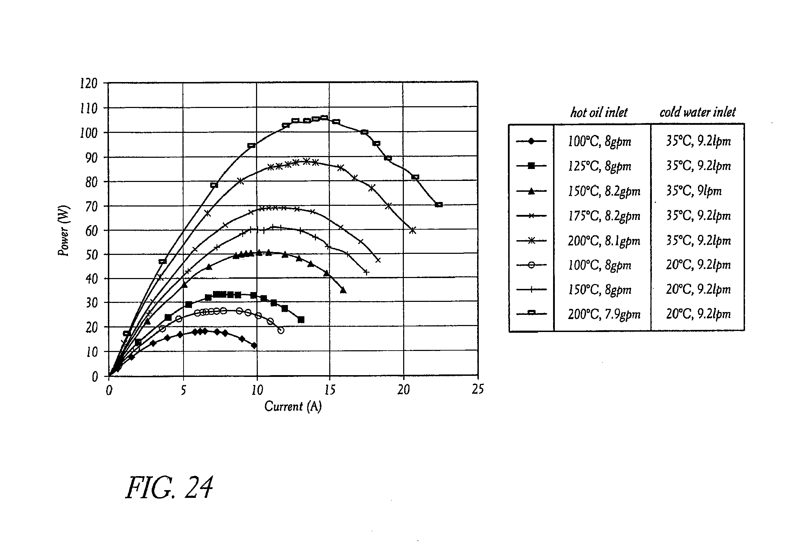

The TE module 1900 illustrated in Figure 19 can be electrically connected with other similar TE modules 1900 to form a TE system. For example, a TE system with an array of sixty TE modules 1900 can be formed similar to the TE system 1400 illustrated in Figure 14. Performance test results for the TE system with sixty TE modules 1900 are illustrated in Figures 23 and 24. Tests were done similarly to those of the TE system 1400 of Figure 14. Cold water inlet temperatures ranged from 20°C to 35°C while the hot oil inlet temperatures ranged from 100°C to 200°C. This TE system had an open circuit voltage greater than 15V at a fluid inlet temperature difference of 180°C with a peak power output of greater than 100W. Power was produced at greater than 250 W/L and greater than 80 W/kg, where volume (e.g. liter) and mass (e.g. kg) include the TE system and heat exchangers, but does not include the fluid or the fluid manifolds connected to the heat exchangers.

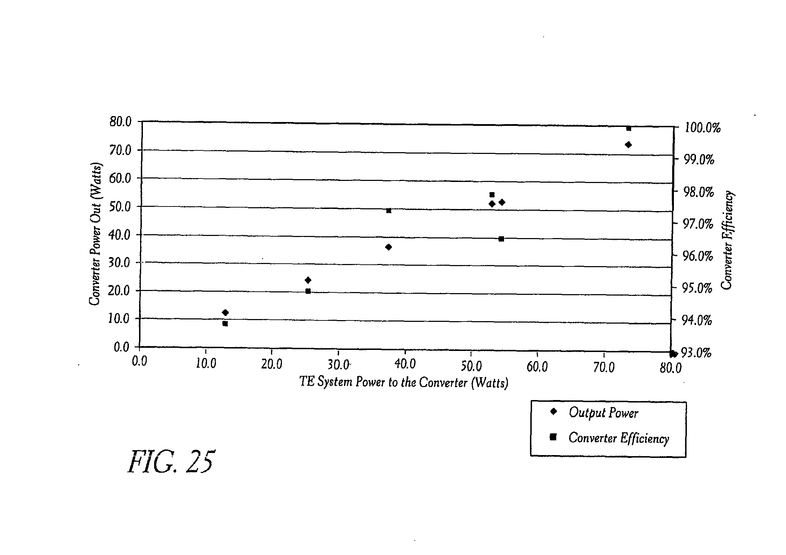

The performance tests discussed above were completed by using a manually varying electrical load. In application, the manual nature would typically not be practical to achieve optimum power output for a range of different output voltage and current conditions. Figure 25 illustrates test performance of a power converter used with the TE system with sixty TE modules 1900 of Figure 19. For power inputs ranging from 0 - 100W, the converter provided output power at efficiencies ranging from 93% to greater than 99% with higher efficiencies occurring at the higher power outputs. These are higher conversion efficiencies than the 85% efficiency of TE systems reported by Nagayoshi, H. et al., "Evaluation of Multi MPPT Thermoelectric Generator System," International Conference on Thermoelectrics, Jeju, Korea. 2007, pp. 323-326.

### Series and/or Parallel Connected Thermoelectric Systems

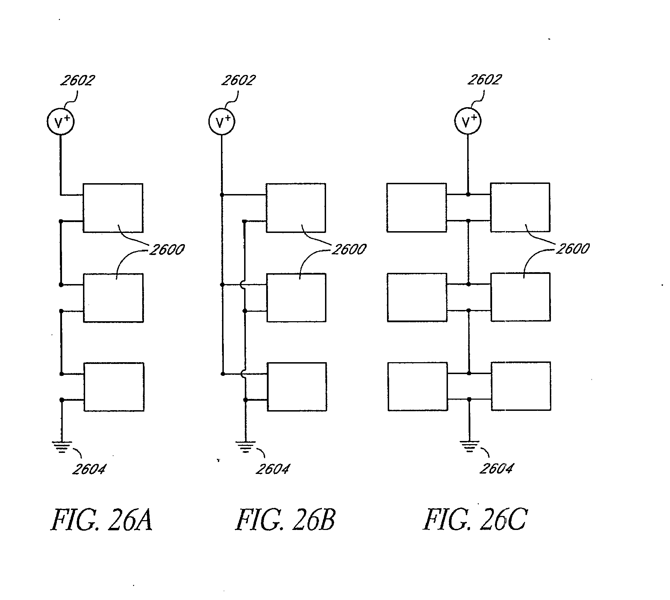

It is advantageous to connect TE systems in series electrical communication to increase the operating voltage, but in parallel electrical communication to improve reliability. The TE modules 100, 1000 illustrated in Figures 1-11 can be configured in series and/or parallel arrangements of several types. Figure 26A illustrates TE modules 2600 electrically connected in series electrical communication. Figure 26B illustrates TE modules 2600 electrically connected in parallel electrical communication. Figure 26C illustrate TE modules 2600 electrically connected in both series and parallel electrical communication. Each of the plurality of TE modules in Figures 26A-C is connected to a voltage source 2602 and ground 2604. In certain embodiments, a thermoelectric system includes a first plurality of TE elements generally in series electrical communication with one another, wherein the first plurality of TE elements are electrically connected to one another in series by a first plurality of electrically conductive shunts, and a second plurality of TE elements generally in series electrical communication with one another, wherein the second plurality of TE elements are electrically connected to one another in series by a second plurality of electrically conductive shunts. At least one electrically conductive element is in electrical communication with at least one of the first plurality of electrically conductive shunts and with at least one of the second plurality of electrically conductive shunts, wherein at least a portion of the first plurality of TE elements is electrically connected in parallel to at least a portion of the second plurality of TE elements by the at least one electrically conductive element.

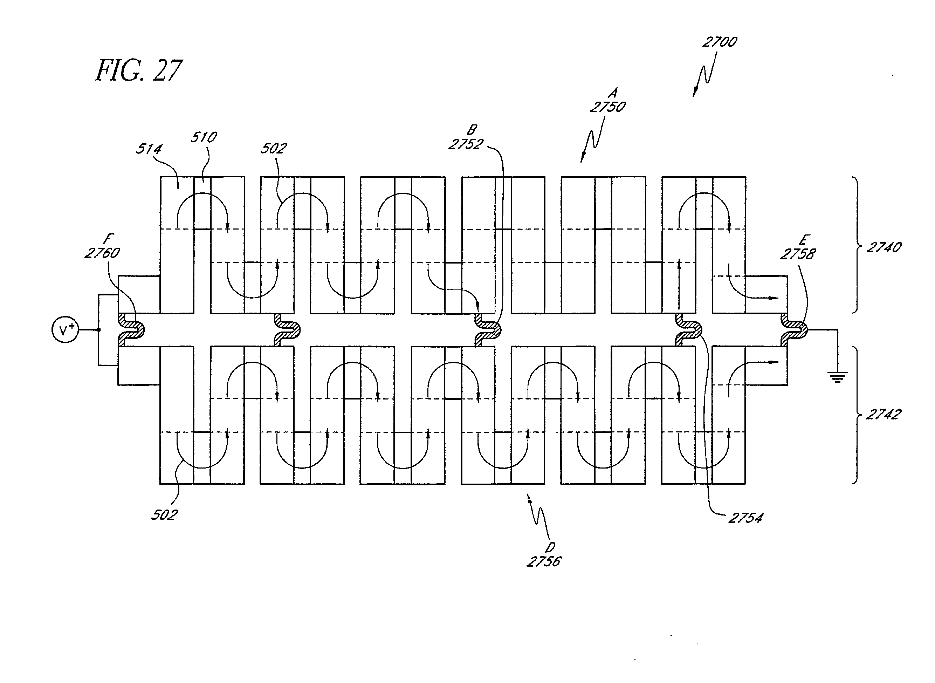

Figure 27 illustrates a TE system 2700 with a first TE module 2740 and a second TE module 2742, similar to those of Figures 5A-C, but modified to incorporate series and parallel redundancy in the electrical connection of the TE system 2700. The first TE module 2740 includes a first plurality of TE elements generally in series electrical communication with one another, and the second module 2742 includes a second plurality of TE elements generally in series electrical communication with one another. The first TE module 2740 and the second TE module 2742 can be arranged generally parallel to one another so that the two TE modules 2740, 2742 each have a net electrical current flow direction generally parallel to one another (e.g., from left to right in Figure 27). The two TE modules 2740, 2742 can be electrically connected to each other at various locations along their lengths to provide parallel redundancy. As illustrated in Figure 27, one or more lower shunts 510 of the first TE module 2740 can be electrically connected to one or more lower shunts 510 of the second TE module 2742 (e.g. a lower shunt 510 of the first TE module 2740 can be electrically connected to an adjacent lower shunt of the second TE module 2742) by electrical conduits 2752, 2754. The electrical conduits can include wires, strings, layers, or other electrically conductive structures. For example, to illustrate the parallel redundancy, if an electrical connection fails, breaks, or is opened in region A 2750 (e.g., between a TE element and a shunt of the first TE module 2740), electrical current can still pass through electrical conduits B 2752 and C 2754 by way of region D 2756 of the second TE module 2742. Thus, in certain embodiments, the parallel redundancy allows current to flow through one or more of the TE elements of the first TE module 2740 which would otherwise be halted due to the break in the series electrical connection along the first TE module 2740. Although, performance of the first TE module 2740 would decrease if such an electrical connection failed, the TE system 2700 would continue to operate with at least a portion of the first TE module 2740 continuing to contribute to the performance. Figure 27 also illustrates redundancy provided by electrical conduits E 2758 and F 2760 where the two TE modules 2740, 2742 are electrically connected in parallel. In certain embodiments, the TE system 2700 can have two or more TE modules.

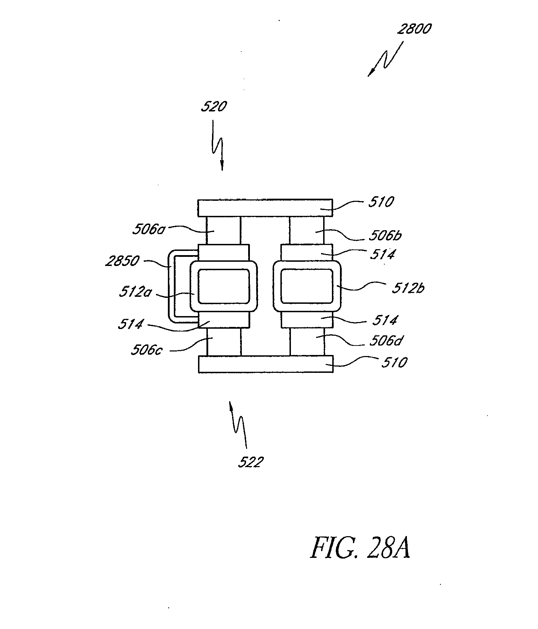

Figure 28A illustrates a TE system 2800 similar to the TE system 700 of Figure 7 but including one or more additional electrical elements 2850. In certain embodiments, the one or more electrically conductive elements 2850 provide electrical communication between one or more TE elements 506a, 506b of the first TE module 520 and one or more TE elements 506c, 506d of the second TE module 522. In certain embodiments, a heat transfer structure includes a first conduit 512a configured to allow working medium to flow in thermal communication with it and at least one second conduit 512b configured to allow working medium to flow in thermal communication with it. A first plurality of TE elements can include a first number of TE elements 506a in thermal communication with a first side of the first conduit 512a and substantially thermally isolated from the at least one second conduit 512b, and a second number of TE elements 506b in thermal communication with a first side of the at least one second conduit 512b and substantially thermally isolated from the first conduit 512a. A second plurality of TE elements can include a third number of TE elements 506c in thermal communication with a second side of the first conduit 512a and substantially thermally isolated from the at least one second conduit 512b, and a fourth number of TE elements 506b in thermal communication with a second side of the at least one second conduit 512b and substantially thermally isolated from the first conduit 512a. A first plurality of electrically conductive elements 2850 in electrical communication with the first number of TE elements 506a and the third number of TE elements 506c, such that at least some of the first plurality of TE elements are in parallel electrical communication with at least some of the second plurality of TE elements. For example, illustrated in Figure 28A, a second shunt 514 of the first TE module 520 is electrically connected by the electrically conductive element 2850 to a second shunt 514 of the second TE module 522. In certain other embodiments, a first shunt 510 of the first TE module 520 can be electrically connected to a first shunt 510 of the second TE module 522 by an electrically conductive element.

Other configurations of electrically conductive elements providing electrical communication between the first TE module 520 and the second TE module 522 can also be used. At described above, the shunts 510, 514 can be in thermal communication with a heat exchanger and/or working medium. In certain embodiments, the first plurality of TE elements are configured to reside substantially in a common first plane, and the second plurality of TE elements are configure to reside substantially in a common second plane. In certain embodiments, the first plane and the second plane are substantially parallel or substantially non-parallel.

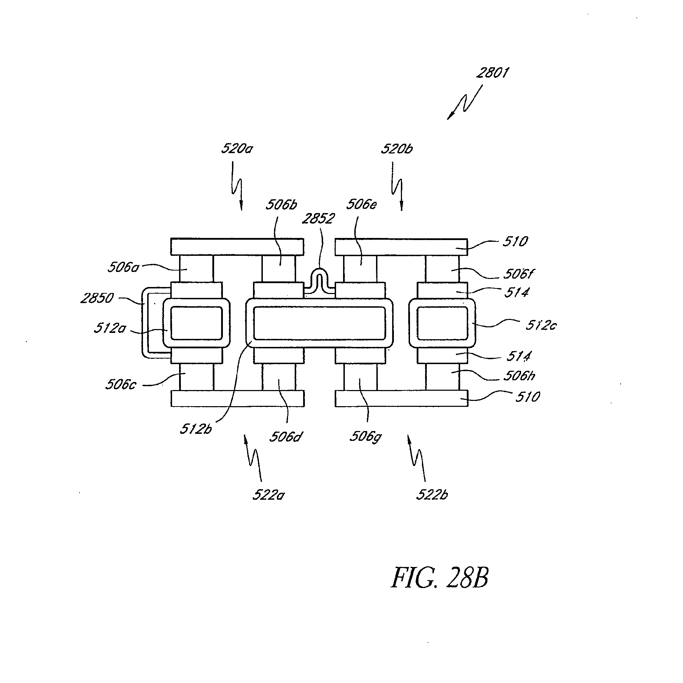

In certain embodiments, the at least one second conduit comprises a plurality of conduits. Figure 28B illustrates a TE system 2801 with four TE modules 520a, 520b, 522a, 522b. The TE system 2801 in Figure 28B is similar to the TE system 2800 of Figure 28A but the at least one second conduit includes a second conduit 512b and a third conduit 512c, a third TE module 520b, a fourth TE module 522b, and one or more additional electrically conductive elements 2852. In certain embodiments, the heat transfer structure further includes the third conduit 512c configured to allow working medium to flow in thermal communication with it. The TE system 2801 can include a third plurality of TE elements generally in series electrical communication with one another, and a fourth plurality of TE elements generally in series electrical communication with one another. The third plurality of TE elements can include a fifth number of TE elements 506e in thermal communication with the first side of the second conduit 512b and substantially thermally isolated from the third conduit 512c, and a sixth number of TE elements 506f in thermal communication with the first side of the third conduit 512c and substantially thermally isolated from the second conduit 512b. The fourth plurality of TE elements can include a seventh number of TE elements 506g in thermal communication with the second side of the second conduit 512b and substantially thermally isolated from the third conduit 512c, and an eighth number of TE elements 506h in thermal communication with the second side of the third conduit 512c and substantially thermally isolated from the second conduit 512b. A second plurality of electrically conductive elements 2852 in electrical communication with the second number of TE elements 506b and with the fifth number of TE elements 506e, such that the first plurality of TE elements are in parallel electrical communication with the third plurality of TE elements. For example, as illustrated in Figure 28B, the second electrically conductive element 2852 electrically connects the first TE modules 520a with the third TE module 520b. The first TE modules 520a can also have one or more electrical connections between the second module 522a. For example, as illustrated in Figure 28B, the first electrical connection 2850 can electrically connect the first TE module 520a with the second TE module 522a.

In certain embodiments, at least one of the first TE module 520a or the third TE module 520b is in electrical communication with the second TE module 522a or the fourth TE module 522b. In certain embodiments, at least one of the first TE module 520a or the second TE module 522a is in electrical communication with the third TE module 520b or the fourth TE module 522b. For example, a third plurality of electrically conductive elements can be in electrical communication with the fourth number of TE elements 506d and with the seventh number of TE elements 506g, such that the second plualrity of TE elements are in parallel electrical communication with the fourth plurality of TE elements. Other configurations are possible. For example, the TE system can include additional TE modules, conduits and/or electrically conductive elements. In certain embodiments, the third plurality of TE elements are configured to reside substantially in a common third plane, and the fourth plurality of TE elements are configure to reside substantially in a common fourth plane. In certain embodiments, the third plane and the fourth plane are substantially parallel or substantially non-parallel.

### Composite Heat Transfer Structures

Heat exchangers are often constructed from extruded aluminum hollow shapes because of the relatively low cost and the formability to form heat transfer enhancement features during or after the extrusion process. However, copper is generally better than aluminum for the shunts that electrically connect TE elements to one another. For example, copper generally has better solderability, lower electrical resistivity and lower thermal resistivity than does aluminum. Therefore, TE modules commonly have copper shunts with aluminum heat exchangers attached. However, copper generally has a lower CTE than aluminum and the coefficient of thermal expansion (e.g. CTE) difference or CTE mismatch between aluminum and copper is generally large enough to create residual stresses in the TE module (e.g. when the components of the TE module cool after being soldered together fro assembly).

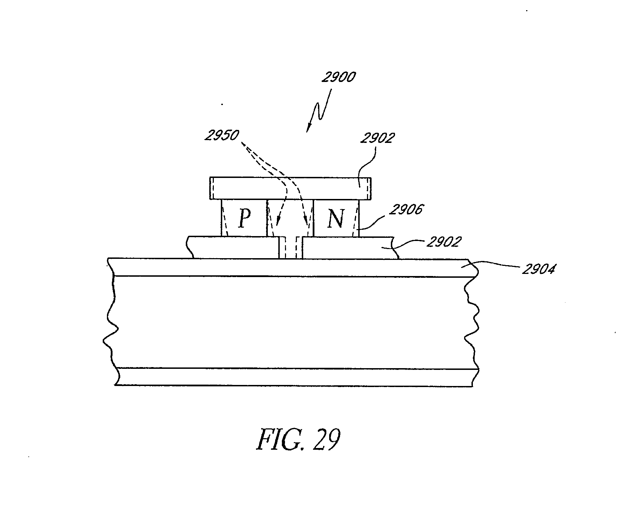

Figure 29 illustrates an example of a TE module 2900 with residual stresses created from the CTE mismatch of a copper shunt 2902 and an aluminum heat exchanger 2904. Solder generally solidifies at a temperature higher than room temperature. After the solder between a copper shunt and a TE element solidifies, the components continue to cool. As the components cool, the components constrict or shrink in accordance with to their CTE. The copper shunt 2902 has a lower CTE than does the aluminum heat exchanger 2904 so the copper shunt 2902 constricts less than the aluminum heat exchanger 2904 for the same temperature decrease. The dotted lines 2950 illustrated in Figure 29A show the induced stresses that the CTE mismatch creates in the TE elements 2906 and in the TE element and shunt interfaces. The induced stress can cause damage and failure of a TE module. Copper and aluminum were used to illustrate the above example; however, the above example is applicable to any two or more materials with different coefficient of thermal expansions.

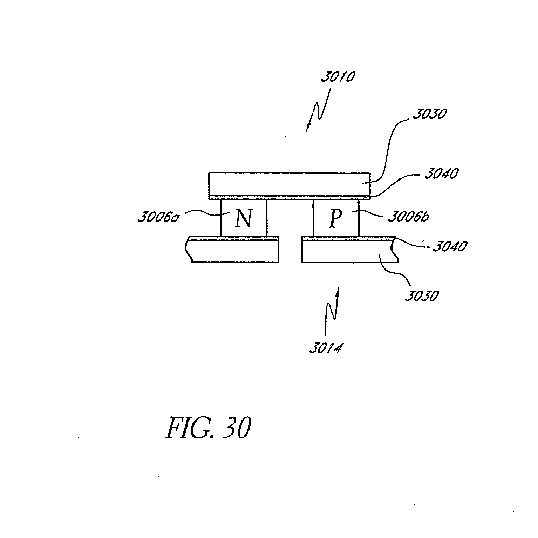

In certain embodiments, a thermoelectric system includes one or more elongate shunts that include a plurality of layers. Figure 30 illustrates a portion of a TE module 3000 with a first shunt 3010 and second shunts 3014. The TE module 3000 can include a first TE element 3006a and a second TE element 3006b on a first side of the first shunt 3010. The first TE element 3006a and the second TE element 3006b are in electrical communication and in thermal communication with the first shunt 3010. The first TE element 3006a can be spaced from the second TE element 3006b. A second side of the first shunt 3010 can include a heat transfer structure in thermal communication with the first shunt 3010. In certain embodiments, one or more of the shunts 3010, 3014 is a composite with one or more of the layers being a different material than another layer. For example, the shunt 3010, 3014 can have a first layer 3030 of a first material and at least one second layer 3040 of a second material. In certain embodiments, the shunt 3010, 3014 is a bimetal composite. In certain embodiments, the at least one second layer 3040 includes at least a portion of the first side of the shunt 3010, 3014 and/or the second layer 3040 is between the first layer 3030 and the TE elements 3006a, 3006b. In certain embodiments, the first layer 3030 is thicker than the second layer 3040. In certain embodiments, the first layer 3030 comprises a lightweight and electrically conductive material (e.g. aluminum, magnesium, pyrolytic graphite, lithium-aluminum alloy), and at least a portion of the second layer 3040 comprises a solderable material (e.g. copper, nickel, silver, gold, or alloys including these elements). In certain embodiments, the solderable portion of the second layer 3040 can be an inlay, overlay or otherwise a portion of the shunt which is to be soldered. In certain embodiments, the first layer 3030 comprises aluminum and the second layer 3040 comprises copper. The first layer 3030 can be a material that has a substantially equal CTE as that of the heat exchanger with which it is in thermal communication. For example, if the heat exchanger is aluminum, the first layer 3030 can also be aluminum. The at least one second layer 3040 in certain embodiments does not distort substantially the curvature of the first layer 3030 (e.g. over a predetermined temperature range, such as between -200 °C and +700 °C). The second layer 3040 can be sufficiently thin such that the shunt 3010, 3014 has a thermal expansion substantially equal to the thermal expansion of the first layer 3030, and/or the CTE of the shunt 3010, 3014 is substantially equal to that of the first layer 3030. Therefore, the shunt 3010, 3014 and the heat exchanger have similar CTE, and induced stresses can be reduced as compared to a system in which the shunt and the heat exchanger have different CTE. Advantageously, the copper layer in the shunt 3010, 3014 can be relatively thin since copper is typically more expensive than aluminum. In certain embodiments, the thickness of the copper layer is only as thick as to facilitate soldering. In certain embodiments, the first layer 3030 and the second layer 3040 are bonded together. For example, the second layer 3040 is a metal cladding or electroplated layer on the first layer 3030. In certain embodiments, the shunt does not curl with temperature change since curling can introduce a form of detrimental stress to the TE module 3000. For example, a thermostatic bimetal is a composite that is typically designed to not curl. In certain embodiments, at least a portion of the shunt comprises a thermally active material (e.g. a bimetal which undergoes a change of dimensions because of differences in the thermal expansion characteristics of two or more materials).

### Heat Transfer Structures with Thermal Conduction Isolation

Thermal isolation in the direction of the working medium flow can improve TE system performance. In certain embodiments, a TE system has at least partial thermal isolation in the direction of flow of a working medium. In certain embodiments, the TE system includes at least one TE element with a heat transfer device in thermal communication with the at least one TE element. The heat transfer device can be configured to allow working medium to flow in thermal communication with the heat transfer device. In certain embodiments, the heat transfer device has a first thermal conductivity in a direction of working medium flow and a second thermal conductivity in a direction generally perpendicular to the direction of working medium flow. The second thermal conductivity is generally higher than the first thermal conductivity.

Finned heat exchangers are often used as a heat transfer device. However, they are often continuous in the direction of working medium flow resulting in minimal thermal isolation. The finned heat exchangers can be sectioned into separate pieces and individually applied to the TE element to create thermally non-conductive gaps between the separate pieces. A TE module with finned heat exchangers can have two or more sections separated by a thermally non-conductive gap. Each section can be separated in the direction of working medium flow. For example, a typical 40 mm x 40 mm TE module can have a finned heat exchanger sectioned into four 10 mm x 40 mm sections with gaps between the sections of about 0.7 mm. The sections are arranged so that the 10 mm dimension is in the direction of the working medium flow and the gaps space the sections apart from one another in the direction of working medium flow. Thus, the four sections span a total of 42.1 mm in the flow direction, and the extra 2.1 mm is divided into two ~1 mm overhangs at the working fluid entry and exit sides of the TE module. However, it is often more costly to produce a TE system with multiple sectioned finned heat exchangers than to have a single finned heat exchanger. To purchase multiple sections is also often more costly than a single piece even though the amount of material is similar, and the cost of assembling multiple sections is often higher than assembling a single section.

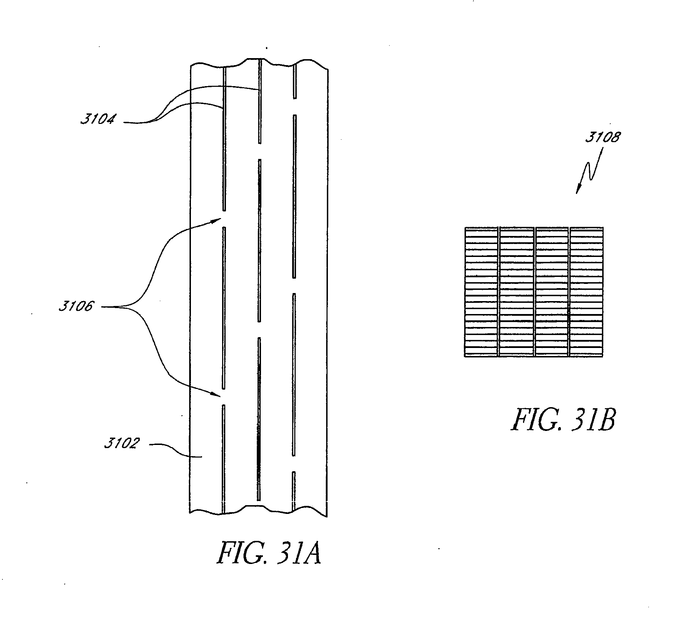

In certain embodiments, a single section heat exchanger provides substantial thermal isolation in the direction of working medium flow. In certain embodiments, the heat exchanger includes a body of a thermally conductive material having a plurality of elongate slots therethrough. The slots can be generally perpendicular to a direction of working medium flow. The body can have a plurality of folds and a plurality of portions generally parallel to one another and parallel to the direction of working medium flow. The body has a first thermal conductivity in a direction of working medium flow and a second thermal conductivity in a direction generally perpendicular to the direction of working medium flow. In certain embodiments, the second thermal conductivity is higher than the first thermal conductivity. The heat transfer device can be produced from a single sheet of thermally conductive material. Figure 31A illustrates a sheet 3102 with a plurality of elongated slots 3104 formed into the sheet 3102. In certain embodiments, two or more slots of the plurality of elongated slots extend along a common line generally perpendicular to the direction of working medium movement. The two or more slots along the common line each have a length and are spaced from one another by a portion of material having a width substantially smaller than the length. The portion of material between the slots can act as tie bars 3106 that hold the body together as one piece. The sheet 3102 can be folded along multiple lines generally perpendicular to the slots 3104 to form a finned structure 3108, as illustrated in Figure 31B. For example, each fold is folded at angles of about 90 degrees. In certain embodiments, the ratio of the lengths of the elongated slots and of the tie bars is relatively small. In certain embodiments, the tie bars are only large enough to hold the body together as one piece. For example, the ratio of the length of the tie bars to the length of the elongated slots is 1:10 for the heat transfer device illustrated in Figures 31A and 31B. In certain embodiments, the width of the material between the slots along a common line divided by the length of the slots is about 1/10 to 1/1000. In certain embodiments, the tie bars are arranged to maintain mechanical stability of the heat transfer device, while minimizing the heat transfer between sections of material across the slots.

In certain embodiments, the tie bars are arranged in a periodicity similar to the periodicity of the fins. The tie bars can be located so that the heat transfer through the tie bars is minimized. For example, the tie bars can be at points furthest from the thermal contacts between the heat transfer device and the TE module. With the tie bars at such a point, the tie bars could be removed (e.g. mechanically, etc.) once the heat transfer device is mounted to the TE module. The tie bars can be randomly located or staggered, as illustrated in Figures 31A and 31B. The tie bar location with respect to the folds can be periodic but can also be non-periodic.

In certain embodiments, the heat transfer device includes two or more slots extending along a common line. In certain embodiments, the heat transfer device includes a plurality of groups of slots, each group of slots including a plurality of slots extending along a corresponding common line, and the common lines of the groups of the slots are generally parallel to one another.

The ratio of the length of the elongated slots to the length of the tie bars between the elongated slots can be varied. For example, the ratios can be random. The length of the elongated slots and the tie bars can also be varied or randomized. The width of the material portion between two separate common lines can also be of varied or randomized. Furthermore, the shape and size of the slots can be varied.

The heat transfer device, as discussed above, can have any a variety of shapes and sizes. For example, a heat transfer device can be produced for a 40 mm x 40 mm TE module using a sheet 42.1 mm wide with three rows of slots formed into it. The slots can be 0.7 mm wide and 50 mm long with a selected space between slots on a common line can be 5 mm. The parallel common lines of the three rows or groups of slots can be separated from one another by 10 mm. The sheet can be folded to form fins with a selected height of the fins. The length of the sheet can be dependent on the desired length of the heat transfer device and the height of the fins.

The above heat transfer devices can be used with any heat exchange fluid including gas, liquid, etc. For example, the heat exchange fluid can be air flowing over and/or through the heat transfer device. The slots can be formed by slitting, lancing, shearing, punching or any other form of separation.

Thermal isolation or formation of slots in the heat transfer device can also be performed after the heat transfer device has been attached to the TE module. For example, the heat transfer device can be adhesive bonded, soldered or brazed to the TE module. Portions of the heat transfer device can then be removed to form slots or other thermal isolation features. Removal methods can include shearing, laser cutting, grinding, chemical etching, any other suitable technique, etc. The other thermal isolation features can be any other structure that can locally make the thermally conductive material generally discontinuous in the direction of flow. The thermal isolation feature can include offsets, louvers, lances, scallops, off-set fins, slotted fins, louvred fins, pin fin arrays, bundles of wires, etc. In certain embodiments, the thermal isolation feature can be contained within or be part of the heat transfer device.

Heat transfer devices with other types of structures or features can be used to provide anisotropic heat transfer characteristics to create at least partial thermal isolation in the direction of flow of a working medium. In certain embodiments, the sheet includes a second material between rows of a thermally conductive material. The second material can be a relatively low thermal conductivity material. The second material can hold together the rows of thermally conductive material. The second material can be, for example, Kapton, Mylar, Nomex paper, etc. The form of the second material can be, for example, strips, wires, tabs, etc. In certain embodiments, the second material can be removed after the heat transfer device has been attached to a TE module. For example, the second material can be aluminum attached between the rows of copper. The aluminum can be subsequently chemically or otherwise removed. Other second materials that can be removed from the thermally conductive material can also be used. For example, the second material can have a lower melting point than the thermally conductive material so that the second material can be removed by heating the heat transfer device. Examples of possible second materials are wax, a low melting point plastic, etc. Solvents and other treatments can also be used to remove the second material.

In certain embodiments, a plurality of fins can be fabricated from materials having a first thermal conductivity in the direction of the flow while having a second thermal conductivity in the direction generally perpendicular to the flow, with the second thermal conductivity higher than the first thermal conductivity. For example, the first thermal conductivity can be relatively low thermal conductivity and the second thermal conductivity can be a relatively high thermal conductivity. Such anisotropic heat transfer characteristics can at least partially thermally isolate adjacent thermoelectric sections and can have similar advantages to that of physically separated heat transfer devices as described above.

A variety of materials can be used to make an anisotropic thermally conductive heat transfer device. In certain embodiments, the heat transfer device can be a homogeneous material that intrinsically has anisotropic thermal conductivity properties. For example, eGraf thermal spreading material from GrafTech (Cleveland, OH) which is based on pyrolythic graphite can be used. This material has a relatively high anisotropic thermal conductivity properties with a thermal conductivity of up to about 500 W/m-K in at least one direction while having a thermal conductivity of about 5-10 W/m-K in a perpendicular direction.

In certain embodiments, the heat transfer device can be a heterogeneous material that has anisotropic thermal conductivity properties. For example, a woven ribbon can be formed by threads extending generally along a direction of the working medium flow (e.g. direction of ribbon length) having low thermal conductivity and by threads extending along a direction generally perpendicular to the direction of the working medium flow (e.g. direction of ribbon width) having high thermal conductivity. The low thermal conductivity threads can be made of plastic (e.g. polypropylene, Teflon, polyimide, etc.), glass, adhesive or any other material with a thermal conductivity lower than the high thermal conductivity threads. The high thermal conductivity threads can be metals (e.g. wires or ribbons of copper, aluminum, etc.), ceramics, carbon or other high thermal conductivity fibers (e.g. carbon nanotubes), inorganic fibers or sheets (e.g. mica), or other material with a thermal conductively higher than the low thermal conductivity threads.

The heterogeneous material can include a continuous relatively low thermal conductivity material that is impregnated with a relatively high thermal conductivity material. The high thermal conductivity material can extend in a direction generally perpendicular to the direction of the working medium flow. The low thermal conductivity material can be a sheet and be made of plastic ribbon, plastic film or any material with a thermal conductivity material lower than the high thermal conductivity material. The high thermal conductivity material can be impregnated into low thermal conductivity material by, for example, press fitting, casting, adhesive attachment, other joining method, etc. Advantageously, a continuous anisotropic thermally conductive heat transfer device generally has a lower cost to manufacture than physically separated sections of a heat transfer device. Also, a continuous heat transfer device is generally simpler to fabricate and assemble with the TE module than a plurality of physically separate sections of a heat transfer device.

In certain embodiments, at least a portion of the thermoelectric system is in proximity of a wicking agent to allow moisture transfer from the system to the wicking agent. In certain such embodiments, at least a portion of the heat transfer device is a wicking agent. In certain embodiments, the wicking agent comprises a material (e.g. cotton, polypropylene, or nylon) configured to control water condensed by the thermoelectric system. In certain embodiments, the wicking agent is in the form of one or more belts, cords, or threads. In certain embodiments, the wicking agent comprises or is treated with an antibacterial or antifungal agent to advantageously prevent mildew or Legionnaire's disease. Such antibacterial or antifungal agents are known in the art.

Various embodiments have been described above. Although the invention has been described with reference to these specific embodiments, the descriptions are intended to be illustrative and are not intended to be limiting. Various modifications and applications may occur to those skilled in the art without departing from the true spirit and scope of the invention as defined in the appended claims.

## Claims

1. A thermoelectric system comprising:
a first heat transfer structure having a first portion and a second portion, the second portion configured to be in thermal communication with a first working medium;
a second heat transfer structure having a first portion and a second portion, the second portion configured to be in thermal communication with a second working medium;
a third heat transfer structure having a first portion and a second portion, the second portion configured to be in thermal communication with the first working medium;
a first plurality of thermoelectric (TE) elements sandwiched between the first portion of the first heat transfer structure and the first portion of the second heat transfer structure; and
a second plurality of TE elements sandwiched between the first portion of the second heat transfer structure and the first portion of the third heat transfer structure, so as to form a stack of TE elements and heat transfer structures, the second portion of the first heat transfer structure and the second portion of the third heat transfer structure projecting away from the stack in a first direction, the second portion of the second heat transfer structure projecting away from the stack in a second direction generally opposite to the first direction.

2. The thermoelectric system of Claim 1, wherein the first plurality of TE elements are in parallel electrical communication with one another and the second plurality of TE elements are in parallel electrical communication with one another.

3. The thermoelectric system of Claim 1, wherein the first heat transfer structure comprises a plurality of thermally conductive segments spaced from one another in a direction generally perpendicular to a direction of electrical current through the stack and the third heat transfer structure comprises a plurality of thermally conductive segments spaced from one another in a direction generally perpendicular to a direction of electrical current through the stack.

4. The thermoelectric system of Claim 3, wherein the second heat transfer structure comprises a plurality of thermally conductive segments and one or more electrically insulative spacers between the segments of the second heat transfer structure.

5. The thermoelectric system of Claim 1, wherein at least some of the first plurality of TE elements are generally in series electrical communication with one another and at least some of the second plurality of TE elements are generally in series electrical communication with one another.

6. The thermoelectric system of Claim 1, further comprising a material having a lower elastic modulus than the first plurality of TE elements, the material sandwiched between at least one first portion and a neighboring TE element within the stack.

7. The thermoelectric system of Claim 6, further comprises a support structure which holds the stack under compressive force in a direction generally along the stack.

8. The thermoelectric system of Claim 1, further comprising a heat transfer device in thermal communication with the first heat transfer structure, the heat transfer device comprises a heterogeneous material having a first thermal conductivity in a direction of working medium flow and a second thermal conductivity in a direction generally perpendicular to the direction of working medium flow, the second thermal conductivity higher than the first thermal conductivity.

9. The thermoelectric system of Claim 8, wherein the heat transfer device comprises a ribbon comprising a first plurality of threads extending along the direction of working medium flow and a second plurality of threads extending along another the direction, and the first plurality of threads comprise a first material and the second plurality of threads comprise a second material having a thermal conductivity higher than the first material.

10. The thermoelectric system of Claim 9, wherein the first material is selected from the group consisting of plastic, glass and adhesive, and the second material is selected from the group consisting of metals, ceramics, carbon, and inorganic fibers and sheets.

11. The thermoelectric system of Claim 8, wherein the heat transfer device comprises a continuous body and a plurality of layers on or within the body, wherein the layers extend along the direction generally perpendicular to the direction of working medium flow.

12. The thermoelectric system of Claim 8, wherein the heat transfer device comprising a body of a thermally conductive material having a plurality of elongate slots therethrough, the slots generally perpendicular to a direction of working medium movement, the body having a plurality of folds and a plurality of portions generally parallel to one another and parallel to the direction of working medium movement,

13. The thermoelectric system of Claim 12, wherein the body is a unitary piece of material.

14. The thermoelectric system of Claim 8, wherein at least a portion of the heat transfer device is a wicking agent.

15. The thermoelectric system of Claim 8, wherein at least a portion of the system is in proximity of a wicking agent to allow moisture transfer from the system to the wicking agent.
